# EUROPEAN PATENT APPLICATION

(11) **EP 4 672 315 A1**
(43) Date of publication of application: **31.12.2025**
(21) Application number: 25173905.8
(22) Date of filing: 02.05.2025
(51) Int. Cl.: H01L 23/13, H01L 23/15, H01L 23/498

(54) **FABRICATING INTEGRATED CIRCUIT PACKAGES WITH GLASS CORE HYBRID PANELS**

(30) Priority: 27.06.2024 US 202418757167
(71) Applicant: Intel Corporation, Santa Clara, CA 95054 (US)
(72) Inventor: Agarwal, Soham, Chandler, 85225 (US); Bryks, Whitney, Tempe, 85284 (US); Candadai, Aaditya Anand, Chandler, 85226 (US); Cao, Yi, Chandler, 85226 (US); Darmawikarta, Kristof, Chandler, 85249 (US); Duan, Gang, Chandler, 85248 (US); Duong, Benjamin, Phoenix, 85044 (US); Ecton, Jeremy, Gilbert, 85298 (US); Mohammadighaleni, Mahdi, Phoenix, 85048 (US); Hernandez, Kari, Phoenix, 85028 (US); Jimenez, Andrew, Mesa, 85210 (US); Jomaa, Houssam, San Diego, 92128 (US); Konchady, Manohar, Chandler, 85248 (US); Li, Xinyu, Chandler, 85286 (US); Liu, Minglu, Chandler, 85248 (US); Marin, Brandon, Gilbert, 85234 (US); Mishra, Pratyush, Tempe, 85283 (US); Mohapatra, Pratyasha, Tempe, 85283 (US); Mousavi, Seyyed Yahya, Chandler, 85226 (US); Palmer, Travis, San Diego, 92122 (US); Peoples, Joseph, Gilbert, 85296 (US); Pietambaram, Srinivas, Chandler, 85249 (US); Shan, Bohan, Chandler, 85226 (US); Stacey, Joshua, Chandler, 85226 (US); Tanaka, Hiroki, Gilbert, 85295 (US); Wang, Yekan, Chandler, 85286 (US); Yeon, Hong Seung, Chandler, 85249 (US); Zhang, Yingying, Phoenix, 85048 (US)
(74) Representative: Goddar, Heinz J.

(57) **Abstract**

An apparatus comprises a glass core comprising a top surface and a bottom surface opposite the top surface. A plurality of vias extending between the top and bottom surfaces. A metallization layer is over at least a portion of the top surface. An edge is between the top and bottom surfaces. The edge comprises one or more protrusions or one or more cavities. Each of the protrusions or cavities comprises a first surface parallel to the top surface, a second surface non-parallel to the top surface, and a polymer or a metal on the first or second surface.

## Description

### BACKGROUND

In electronics manufacturing, integrated circuit (IC) packaging is a stage of semiconductor device fabrication in which an IC that has been monolithically fabricated on a chip (or die) is assembled into a "package" that can protect the IC chip from physical damage. The package can also communicatively connect the IC chip to other packaged IC chips and/or a scaled host component, such as a package substrate, or a printed circuit board. Multiple IC chips can be co-assembled, for example, into a multi-die package (MCP).

A package substrate provides a means to connect chiplets and passives with extremely high I/O count to a host component, such as a printed circuit board (PCB). Package substrates are often built around a fiberglass resin core with copper on both sides, typically referred to as a copper clad laminate (CCL). The CCL facilitates the creation of redistribution metallization layers (RDL) that connect through the substrate core with plated through holes (PTH). The various RDLs are separated from each other by organic dielectric layers, known as build-up films, which are typically dry film laminates.

Package substrate processing has evolved beyond PCB processing through the use of specialized tooling, such laser drills, and lithography steppers that can reduce RDL feature dimensions to below 5µm line/space (1/s). However, a transition from CCL cores to glass cores may be necessary to further scale feature sizes (e.g., to 2 µm 1/s, and below) and/or to enable larger package substrate sizes (e.g., exceeding 120mm x 120mm). For the manufacture of glass cored package substrates, it would be advantageous to leverage the specialized tooling that has been designed to handle large CCL panel sizes (e.g., 510mm x 515mm and 600mm x 600mm).

### BRIEF DESCRIPTION OF THE DRAWINGS

The subject matter described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Views referred to as "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure. Further, where considered appropriate, reference labels have been repeated among the figures to indicate corresponding or analogous elements. In the figures:
FIG. 1 is a flow diagram illustrating methods for forming an IC package with a glass core hybrid panel, in accordance with some embodiment;
FIGS. 2A and 2B are plan and cross-sectional views of a glass core panel, in accordance with some embodiments;
FIGS. 3A-3E are plan views of glass core panels and frames following formation of sidewall protrusions on the glass core panels, and following formation of a plurality of cavities on the frames, in accordance with some embodiments;
FIGS. 4A-4G are plan and cross-sectional side views of a glass core panel following formation of protrusions on edges of a glass core panel, and following formation cavities on interior edges of a frame, in accordance with some embodiments;
FIGS. 5A-5O are cross-sectional side views of glass core panels following formation of protrusions or cavities on edges of glass core panels, and following formation cavities or protrusions on interior edges of frames, in accordance with some embodiments;
FIGS. 6A-6G are plan and cross-sectional side views of a glass core panel reconstituted into a hybrid panel using a reusable frame, in accordance with some embodiments;
FIGS. 7A-7G are plan and cross-sectional side views of glass core panels and frames comprising projections or cavities integrated into the glass core panels and frames, in accordance with some embodiments;
FIGS. 8A-8D are enlarged cross-sectional side views of features on surfaces of the projections and cavities of the glass core panels and frames illustrated in FIGS. 7A-7G, in accordance with some embodiments;
FIGS. 9A-9E illustrate cross-sectional side views of stages of manufacturing a hybrid glass core panel using a step-in frame, in accordance with some embodiments;
FIGS. 10A-10G are plan and cross-sectional side views of a glass core panel with protrusions and a frame with complementary cavities evolving through several stages of manufacturing, in accordance with some embodiments;
FIGS. 11A-11E illustrate plan views an organic frame with protrusions and a glass core panel with evolving through several stages of manufacturing, in accordance with some embodiments;
FIGS. 12A-12B are plan views of a glass core panel comprising protrusions and cavities on edges of the panel, and a frame comprising protrusions and cavities on interior edges of the frame, in accordance with some embodiments;
FIGS. 13A-13H are cross-sectional side views of glass core panels comprising features on edges of the panels and frames comprising complementary features to receive the features, in accordance with some embodiments;
FIGS. 14A-14E are cross-sectional side views of a glass core panel with interlocking features evolving into a hybrid panel, in accordance with some embodiments;
FIGS. 15A-15C are isometric views of interlocking features for side members of a frame for a glass core panel and a frame comprising side members with the interlocking features, in accordance with some embodiments;
FIGS. 15D-15G are plan and cross-sectional views of a frame for a glass core panel, in accordance with some embodiments;
FIGS. 16A-16G are plan and cross-sectional side views of a frame for a glass core panel, in accordance with some embodiments;
FIGS. 17A-17E are plan and cross-sectional side views of a frame for a glass core panel, in accordance with some embodiments;
FIGS. 18A-18C are plan and cross-sectional side views of a tool for fabricating a frame for a glass core panel, in accordance with some embodiments;
FIGS. 19A-19D are cross-sectional side views illustrating operations on a glass core panel and frame as it evolves into a hybrid panel, in accordance with some embodiments;
FIG. 20 is a cross-sectional view illustrating a microelectronic device assembly which includes glass core package substrate, in accordance with some embodiments;
FIG. 21 illustrates a mobile computing platform and a data server machine employing one or more apparatus comprising a hybrid panel, in accordance with some embodiments; and
FIG. 22 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

It would be an advantage to be able to use tooling that has been designed to handle large CCL panel sizes (e.g., 510mm x 515mm and 600mm x 600mm) in the manufacture of glass cored package substrates. However, glass is more fragile than traditional organic-cored package substrates. Yields may suffer if CCL panels are simply replaced with glass panels due to cracking, seware, chipping, and breaking of the glass when the workpiece is handled by the existing tools. Some existing tools have aggressive rock and shock mechanisms as part of their processing, e.g., Desmear and Eless.

To protect the glass core from damage during manufacturing, a glass core may be reconstituted into a hybrid panel including a frame around peripheral edges of the glass core. Reconstitution of a glass core may also include forming mold or other materials on surfaces and/or edges of the glass core, and on surfaces of the frame. However, one potential problem faced when reconstituting a glass core is that adhesion between glass and organic material may not be sufficient. The coefficient of thermal expansion (CTE) polymers and glass differ which can stress the adhesive interface between glass and the polymer material on the surface of the glass. In addition, organic materials are relatively bendable in comparison to glass. Insufficient adhesion can result in cracking or debonding in the interface between the glass and the frame. Insufficient adhesion may also result in the glass core shifting within the frame. In some cases, a gap between the glass core and the frame may not be completely filled, leaving a void in the gap region. Another challenge is that frames made of CCL and/or other organic materials may not be sufficiently rigid and may bend during handling by existing tools. A further challenge encountered when reconstituting a glass core into a hybrid panel is material waste when fabricating the frame. A variety of example of reconstituted glass-core package substrates and a variety of frames that may be used to hold glass cores during fabrication are described herein. Advantageously, these devices may solve one or more of the potential problems that can arise when reconstituting a glass core into a hybrid panel.

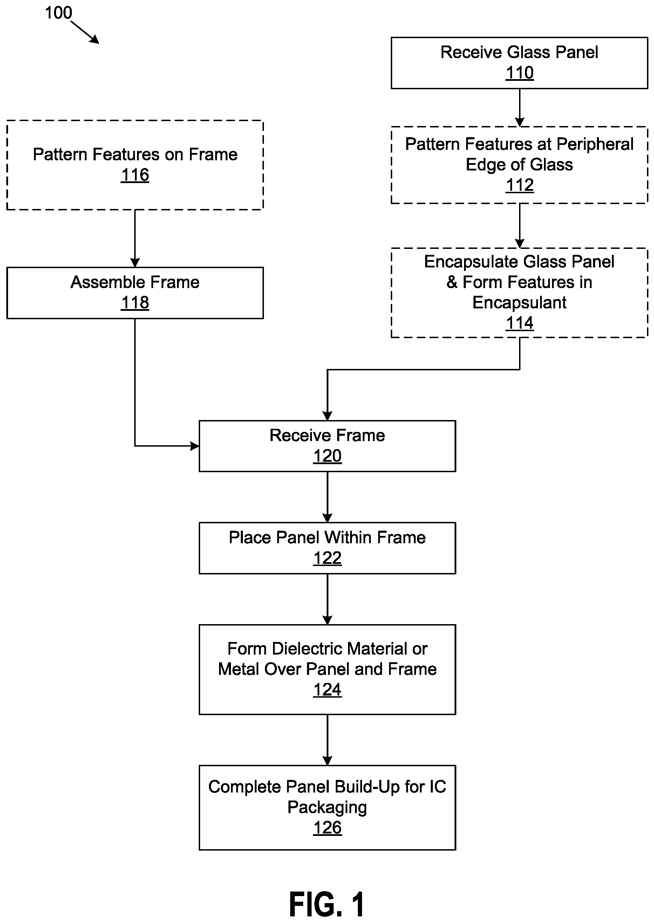

**FIG. 1** is a flow diagram illustrating methods 100 for forming an IC package with a glass core hybrid panel, in accordance with some embodiments. A hybrid panel (or glass core hybrid panel) has one or more glass core panels within a perimeter frame of a material other than glass. A hybrid panel may offer better handling characteristics during a build-up of metallization features and dielectric layers upon the glass core panels, for example with semi-additive processes (SAP), whereby the glass core panel becomes a core of one or more built-up glass-core IC die package substrates. One or more IC die may be assembled with a glass-core substrate into an IC die package. The frame can be separated from the glass-core substrate(s) before or after IC die assembly, at which point the frame may be discarded or reused in another hybrid panel.

Methods 100 include one or more operations performed on a glass core panel received at input 110, on a frame received at input 120, or on both the glass core panel and the frame. As described further below, the operations may improve adhesion between a glass core panel and a frame, for example by increasing the surface area of the glass in contact with the frame, or be providing interlocking features on the glass and the frame.

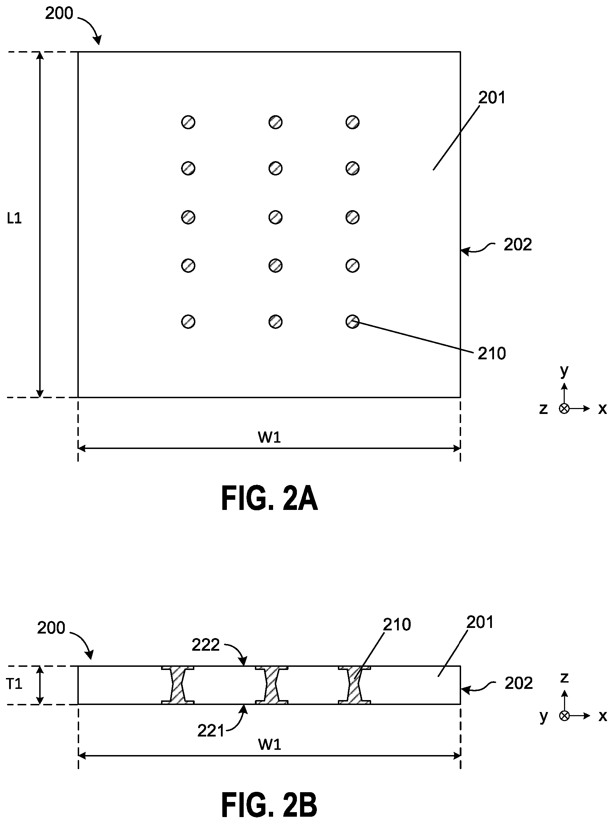

A panel of glass received as a preform at input 110 may have any composition and form factor amenable to being further processed into a glass core of a package substrate. The panel is therefore referred to herein as a "glass core panel." FIGS. 2A and 2B are plan and cross-sectional views of a glass core panel 200, in accordance with some embodiments. The glass core panel 200 is advantageously a single bulk piece of glass 201 that is predominantly silica (e.g., silicon and oxygen) and may further include one or more compositional additives, such as, aluminum, beryllium, magnesium, calcium, strontium barium, radium, tin, sodium, silver potassium, boron, phosphorus, zirconium, lithium, titanium, or zinc. Glass 201 may therefore be any of aluminosilicate, borosilicate, alumino-borosilicate, or silica, etc. The composition of glass 201 may be primarily silicon, oxygen, and aluminum, for example. In some advantageous embodiments, glass 201 has a composition of at least 23 weight percent silicon and at least 26 weight percent oxygen, and further comprising at least 5 weight percent aluminum. In some examples, glass core panel 200 is a photosensitive glass in the lithium-silicate family that can be etched using radiation.

Glass 201 may have any thickness T1 between a first (e.g., bottom) glass surface 221 and a second (e.g., top) glass surface 222. In exemplary embodiments, thickness T1 is less than 1.6 mm, advantageously less than 1mm and more advantageously no more than 500µm. In some examples, glass 201 has a thickness T1 in a range of about 200-400µm. As a preform, glass core panel 200 has a glass edge 202 that is substantially orthogonal to glass surfaces 221 and 222 over the entire glass thickness T1.

Although a glass core panel 200 may consist of only glass 201, in some embodiments glass core panel 200 further comprises non-glass structures embedded in, or formed upon, glass 201, for example, upstream of methods 100 (FIG. 1). Such non-glass structures, if absent from the panel preform received at input 110, may be fabricated during the practice of methods 100. In the example illustrated in FIG. 2A and 2B, glass core panel 200 includes a plurality of conductive through vias 210. The conductive through vias 210 extend through glass thickness T1 and are therefore referred to as through-glass vias (TGVs). In the illustrated example where glass 201 has thickness T1, conductive through vias 210 intersect both opposing glass surfaces 221, 222. As shown, conductive through vias 210 may be arrayed over an area, or footprint, of glass core panel 200. Conductive through vias 210 may be arrayed over any portion of glass core panel 200. Each of conductive through vias 210 comprise a conductive material, such as a metal, embedded within the glass 201. In some examples, the metal is predominantly copper (Cu). Conductive through vias 210 may have any pitch in the x and/or y dimensions. In some embodiments, conductive through vias 210 have a pitch in at least one of x or y dimensions that is less than 5 µm, advantageously less than 2 µm, more advantageously less than 1 µm. In addition to, or in the alternative to, conductive through vias 210, glass core panel 200 may comprise other non-glass structures embedded within glass thickness T1, such as other metallization features (e.g., conductive traces or lines), IC die, MIM capacitor arrays, inductor structures, etc.

Although a glass core panel may have any lateral dimension(s), in the rectangular prism embodiments illustrated in FIG. 2A and 2B, glass core panel 200 has a length L1 and a width W1. In some embodiments, glass core panel 200 is slightly smaller than a large format package substrate (e.g., CCL) panel, for example with a length L1 of about 510mm and width W1 of about 515mm. For such embodiments, a single glass core panel 200 may be incorporated into a single hybrid panel that is approximately the same size as a large format package substrate panel. In alternative embodiments where a plurality of glass core panels 200 are reconstituted within a perimeter frame, length L1 and width W1 may each be scaled down (e.g., to an approximate 200-250mm quadrant of a large format package substrate panel, or an approximate 100-125mm 1/16th sector of a large format package substrate panel). In one example, a plurality of glass core panels 200, each panel of a size appropriate for a single IC device package, are reconstituted within a perimeter frame. Regardless of size, each glass core panel 200 may either be retained as a single unit that is subsequently incorporated into a single IC die package assembly, or each glass core panel 200 may be subsequently cut down into multiple units such that different portions of a single glass core panel 200 is incorporated into different IC die package assemblies.

Referring to FIG. 1, various features may be formed in a glass core panel at operation 112. As described below, these features include protrusions and cavities at edges or on sidewalls of the glass core panel. The features may include holes through the protrusions and cavities, as well as features on surfaces of the protrusions and cavities. Operation 112 may include patterning a glass core panel using laser and etching process, where a laser process modifies the glass material (melts it), which then increases the etch rate of the glass in solution - by this method, preferential etching can achieve myriad shapes by a "sculpting" effect. Since a laser can achieve volumetric focusing anywhere within the space of a glass panel, the process capability is extremely high. Operation 112 may include other methods, such as patterning photo-definable glass. UV irradiation is used (instead of a laser) to modify the glass structure of photo-definable glass. Examples that employ photo-definable glass may include a thermal step which helps to change the glass microstructure only in the UV-exposed region. Such regions then exhibit drastically increased etch rates, allowing shapes to be etched out. Operation 112 may also include mechanical grinding or cutting to pattern the glass. mechanical grinding may be employed to form features that exhibit vertical interlocking geometries. Mechanical grinding may be used to form a convex edge bevel. Mechanical grinding with an inverse of the grind wheel nominally used for glass edge beveling may be useful for forming concave edge instead of a convex edge bevel.

The frame received at input 120 may have any dimensions compatible with that of the glass panels. In some examples, the frame is a unitary body comprising one or more contiguous material layers. In other examples, the frame may be a laminate of metallization and dielectric material. In some examples, the frame comprises a dielectric material, such as Ajinomoto Build-up Film (ABF), mold, or a glass cloth pre-preg material. In some examples, a dielectric material may be an organic dielectric, such as, an epoxy resin, phenolic-glass, or a resinous film such as the GX-series films commercially available from Ajinomoto Fine-Techno Co., Inc. The dielectric material may comprise epoxy resins (e.g., an acrylate of novolac such as epoxy phenol novolacs (EPN) or epoxy cresol novolacs (ECN)). In other examples, the dielectric material includes aliphatic epoxy resin, which may be monofunctional (e.g., dodecanol glycidyl ether), difunctional (butanediol diglycidyl ether), or have higher functionality (e.g., trimethylolpropane triglycidyl ether). In some examples, the frame comprises an epoxy-based laminate (e.g., FR4), or silicon (e.g., monocrystalline). In some examples, the frame comprises metal, e.g., copper, a resin coated copper (RCP), or copper clad laminate (CCL).

Referring to FIG. 1, various features may be formed in a frame at operation 116. As described below, features on a frame comprise shapes that are the complement of shapes of features on a glass core panel. The complimentary shapes on the frame and glass core panel may enable vertical interlocking, horizontal interlocking, or both vertical and horizontal interlocking of a glass panel and a frame for a reconstitution process. Any of the methods described above for forming features on a glass core panel may be used to form features on a frame at operation 116.

Returning to FIG. 1, methods 100 may include assembling the frame for the glass core panel at operation 118. In some examples, the frame is assembled prior to receiving the frame at 120. In other examples, the process of patterning features on the frame at 116 includes assembling the frame. In some examples, a frame is built up over and at edges of a glass core substrate and the features are patterned as part of the build-up process. Accordingly, operation 120 may be a step where an assembled and patterned frame is received, or operation 120 may include either or both of operations 116 and 118.

While methods 100 generally include operation 112 of patterning features at a peripheral edge of a glass core substrate, in some examples these operations are omitted. Referring to FIG. 1, methods 100 may include operation 114 of encapsulating a glass panel in an encapsulant and forming features edges or sidewalls of the encapsulated glass core panel.

After the glass core panel and frame are received, the panel may be placed in the frame at operation 122. A dielectric material may be formed over the assembled glass core panel and frame at operation 124. In some examples, a metal may be formed over the assembled glass core panel and frame at operation 124. At operation 126, the panel build operations for IC packaging may be performed. Operations 124 and 126 are further described below.

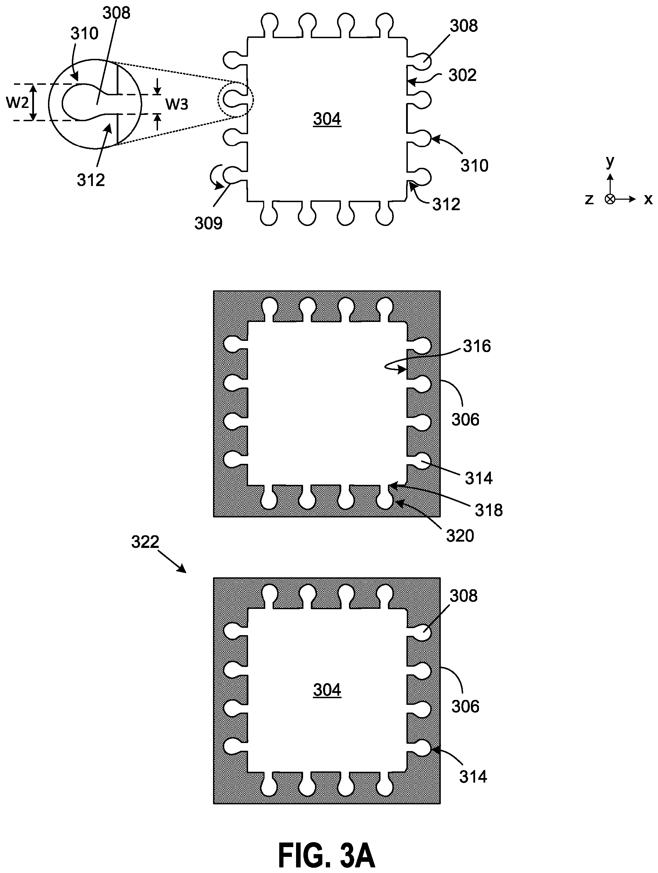

**FIGS. 3A-3E** are plan views of glass core panels and frames following formation of sidewall protrusions on the glass core panels, and following formation of a plurality of cavities on the frames, in accordance with some embodiments. As can be seen in the examples, the protrusions can have a variety of shapes and each cavity comprises a shape to mate with a corresponding protrusion. FIGS. 3A-3E illustrates the contours of the protrusions and cavities in the x-y dimensions - these contours are edges of the features that may extend through a thickness of the glass or frame in a z-direction substantially orthogonal to a surface of the glass panel or frame. A protrusion comprises a proximal end at an edge or sidewall of a glass core panel and a distal portion away from the point where the protrusion connects to the glass. The protrusions and cavities comprise complementary shapes that interlock in the x-y dimensions. For example, a width (in the x or y dimension) of a protrusion at the proximal end may be narrower than a width of its distal portion. In some examples, a protrusion extends in an x- or y-direction substantially perpendicular to the sidewall of the glass core panel. In other examples, a distal portion of a protrusion may comprise a shape with a curved perimeter in the x- or y- direction, such that the projection is asymmetrically shaped with respect to a line extending perpendicular from the sidewall of the glass core panel.

**FIG. 3A** illustrates an example glass core panel 304 after formation of a plurality of bulb-shaped protrusions 308 on sidewalls 302. Protrusions 308 comprise a proximal end 312 at an edge or sidewall 302 of glass core panel 304 and a distal portion 310 away from where the protrusion connects to the glass at the sidewall. In the example of FIG. 3A, a width W3 of protrusion 308 at proximal end 312 is narrower than a width W2 at distal portion 310, as illustrated in the expanded view of FIG. 3A. The shape of distal portion 310 includes a shape with a curved perimeter 309 in some examples. An example frame 306 is also illustrated in FIG. 3A. Frame 306 has an interior sidewall 316 comprising a plurality of cavities 314, each shaped to mate with one of the plurality of protrusions 308. A shape of a protrusion 308 on a glass core panel sidewall and a shape of a cavity 314 on an interior sidewall of a frame may be complements. For example, a cavity 314 includes a first end 318 at interior sidewall 316 and a second end 320 opposite first end 318. Like protrusions 308, cavities 314 may extend through a thickness of the frame in a z-direction substantially orthogonal to a surface of the frame. FIG. 3A also illustrates an example 322 of glass core panel 304 after it has been inserted into frame 306.

While the shape of a protrusion 308 and a shape of a cavity 314 may be complements, the cavity may be slightly larger than the protrusion to facilitate insertion of the protrusion in the cavity and/or as a result of manufacturing variations. Accordingly, there may be one or more small gaps (not illustrated in the figures) between a protrusion 308 and a cavity 314 along thickness of the glass or frame in a z-direction. A polymer material, e.g., mold, may be formed over a surface of a glass core panel within a frame in a manufacturing operation. In some examples, a polymer material may be in a gap between the frame and the glass core panel as a byproduct of the manufacturing operation. In other examples, the cavity may be made larger than the protrusion so as to provide a gap to receive a polymer material. In these examples, a polymer material may be in the gap between the frame and the glass core panel.

**In** various embodiments, frame 302 may comprise polymer material, a metal, or other frame material described herein. After a glass core panel 304 has been inserted into frame 306 as illustrated by example 322, portions of the frame 302 are between (in the y- or x-direction) first and second adjacent protrusions 308 on a sidewall 302 of the glass core panel 304. Accordingly, in some examples, a glass core hybrid panel comprises a polymer material, a metal, or other frame material between first and second adjacent protrusions 308.

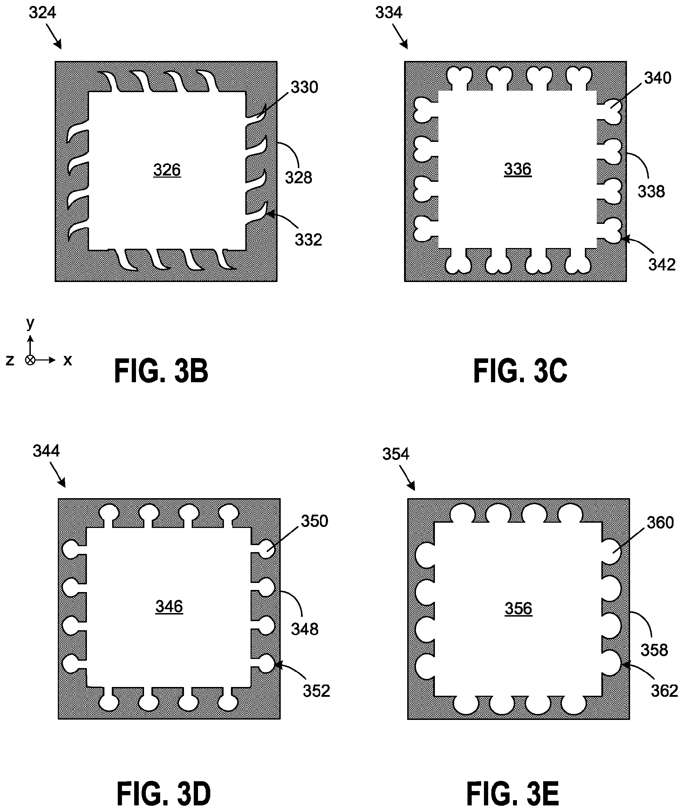

**FIG. 3B** illustrates an example 324 of a glass core panel 326 after it has been inserted into frame 328. Glass core panel 326 comprises protrusions 330 that have a shape in the x, y dimensions that resembles a wave. Frame 328 comprises cavities 332 that have shapes in the x, y dimensions that complement the shapes of protrusions 330.

**FIG. 3C** illustrates an example 334 of a glass core panel 336 after it has been inserted into frame 338. Glass core panel 336 comprises protrusions 340 that have a shape in the x, y dimensions that resembles a dog bone. Frame 338 comprises cavities 342 that have shapes in the x, y dimensions that complement the shapes of protrusions 340.

**FIG. 3D** illustrates an example 344 of a glass core panel 346 after it has been inserted into frame 348. Glass core panel 346 comprises protrusions 350 that have a shape in the x, y dimensions that resembles a dumb bell. Frame 348 comprises cavities 352 that have shapes in the x, y dimensions that complement the shapes of protrusions 350.

**FIG. 3E** illustrates an example 354 of a glass core panel 356 after it has been inserted into frame 358. Glass core panel 356 comprises protrusions 360 that have a shape in the x, y dimensions that resembles a hole punch. Frame 358 comprises cavities 362 that have shapes in the x, y dimensions that complement the shapes of protrusions 360.

In various embodiments, frames 328, 338, 348, and 358 may comprise polymer material, a metal, or other frame material described herein. After respective glass core panels 304 has been inserted into frames 328, 338, 348, and 358, portions of the respective frames are between (in the y- or x- direction) first and second adjacent protrusions 330, 340, 350, and 360 on a sidewall of the glass core panel. Accordingly, in some examples, a glass core hybrid panel comprises a polymer material, a metal, or other frame material between first and second adjacent protrusions 330, 340, 350, and 360.

While FIGS. 3A-3E illustrate glass core panels with protrusions on their sidewalls and frames with complementary cavities on interior sidewalls, in some examples, that these configuraations are reversed. In some embodiments, glass core panels comprise cavities on their sidewalls and frames comprise complementary protrusions on interior sidewalls. The cavities on the glass core panels may have any of the shapes shown for cavities on frames in FIGS. 3A-3E. The protrusions on frames may have any of the shapes shown for protrusions on glass core panels in FIGS. 3A-3E. As noted, a frame may comprise polymer material, a metal, or other frame material described herein. After a glass core panel having cavities has been inserted into frame having protrusions, portions of the frame are between (in the y- or x-direction) first and second adjacent cavities on a sidewall of the glass core panel. Accordingly, in some examples, a glass core hybrid panel comprises a polymer material, a metal, or other frame material between first and second adjacent cavities on a sidewall.

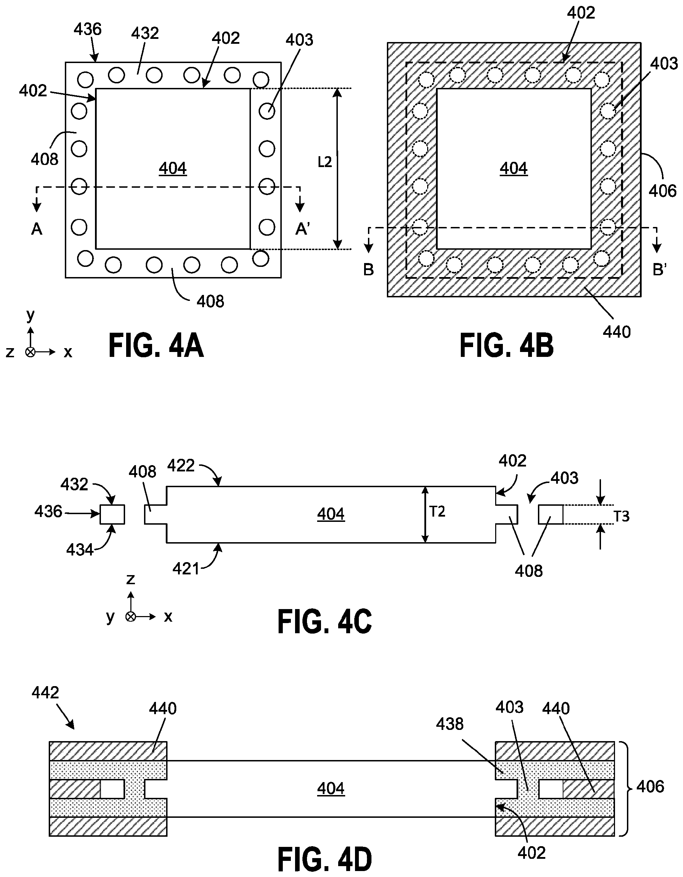

**FIGS. 4A-4F** are plan and cross-sectional side views of a glass core panel following formation of protrusions on edges of a glass core panel, and following formation cavities on interior edges of a frame, in accordance with some embodiments. FIGS. 4A-4F illustrate one example of protrusions that extend laterally away (in x- or y-dimensions) from edges of a glass core panel. Advantageously, the protrusions and cavities enforce vertical interlocking of a glass core panel and a frame for a reconstitution process.

**FIGS. 4A** and **4C** illustrate an example glass core panel 404 after formation of one or more protrusions 408 on edges 402 of the glass core panel, and after formation of holes 403 in the protrusions 408. FIG. 4C is a cross-sectional side view taken along line A-A' of FIG. 4A. The glass core panel 404 comprises a top surface 422 and a bottom surface 421 opposite the top surface. In addition, the glass core panel 404 comprises edges 402 between the top and bottom surfaces 422, 421. An edge 402 may comprise one or more protrusions 408. Each of the protrusions 408 comprise a first surface 432 parallel to the top surface 422, a second surface 434 opposite first surface 432, and a third surface 436 non-parallel to the top surface, e.g., orthogonal to top surface 422. In the illustrated example, one of more holes extending between first and second surfaces 432, 434 are formed in protrusions 408. The glass core panel 404 has a thickness T2 and the protrusions 408 have a thickness T3, where T3 is less than T2. The protrusions 408 may have a lateral dimension (in the y- or x-dimension) that extends a length L2 of an edge 402, or that extends a distance longer or shorter than the length L2 of the edge 402. As described below, a polymer or a metal may be on the first or second surface, or within a hole 403.

**FIGS. 4B** and **4D** illustrate an example 442 of the glass core panel 404 after it has been inserted into frame 406. FIG. 4D is a cross-sectional side view taken along line B-B' of FIG. 4B. The locations of edges 402 and holes 403 are shown with dashed lines in FIG. 4B. In the illustrated example, frame 406 comprises a polymer material 438 and metal 440. In embodiments, polymer material 438 may be a dielectric such as ABF, mold, or pre-preg material. A pre-preg material may be a sheet or strip comprising fiber and resin. As shown in FIG. 4D, the polymer material 438 may be placed in holes 403. In other examples, the polymer material 438 may be placed in grooves, or indentations in a glass core panel. The polymer material 438 may also be placed on edges 402, and on any of the first, second, and third surfaces 432, 434, 436 of protrusions 408. The polymer material 438 can be used in a reconstitution process to "glue" a glass core panel to a frame. In some examples, metal 440 can be placed on edges 402, on any of the first, second, and third surfaces 432, 434, 436 of protrusions 408, or on polymer material 438. In embodiments, the metal 440 is copper or another suitable metal or alloy.

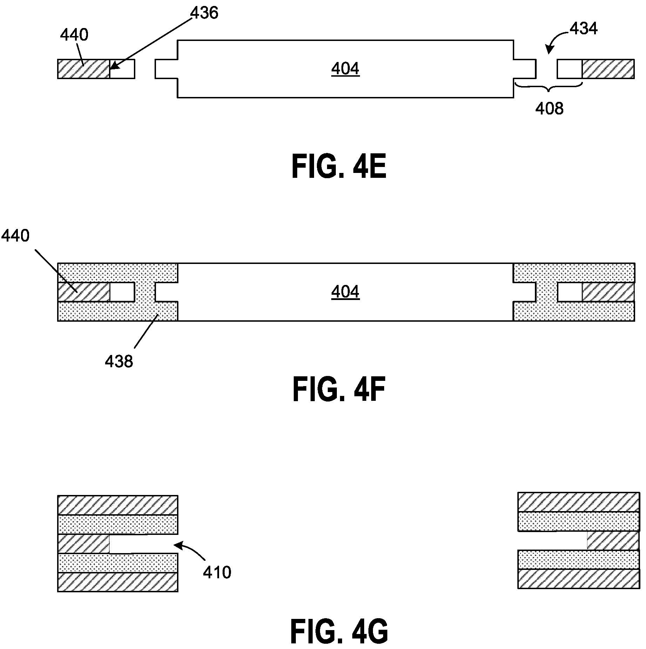

**FIG. 4E** is a cross-sectional side view of glass core panel 404 after metal 440 has been placed on third surface 436. **FIG. 4F** is a cross-sectional side view of glass core panel 404 after polymer material 438 has been placed within hole 403, on first and second surfaces 432, 434 of protrusions 408, and on metal 440. Referring again to FIG. 4D, the figure illustrates a stage of manufacturing after metal 440 has been placed on polymer material 438. **FIG. 4G** is a cross-sectional side view of frame 406 without glass core panel 404 illustrating a cavity 410 on interior edges of the frame.

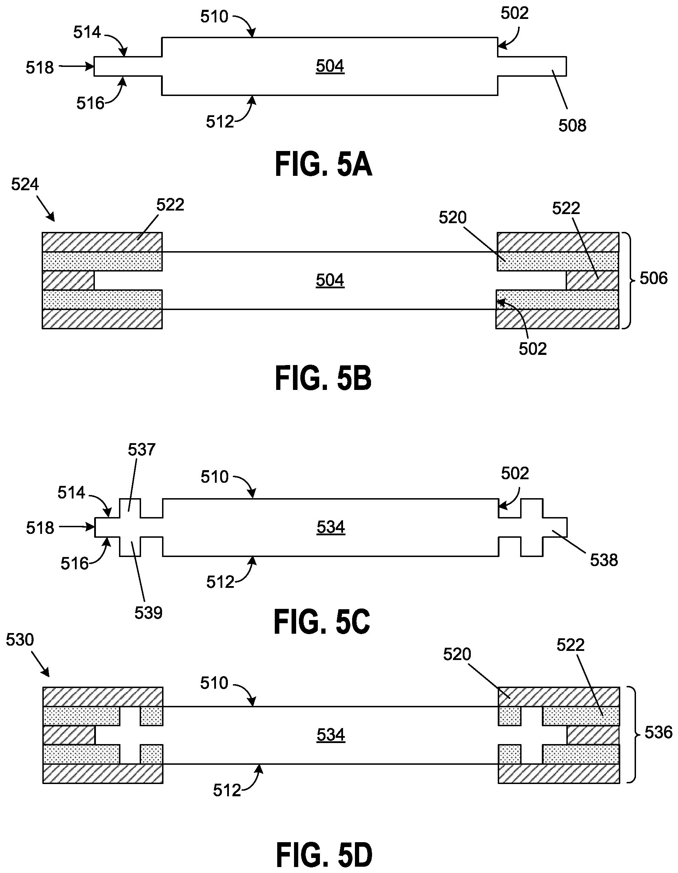

**FIGS. 5A-5O** are cross-sectional side views of glass core panels following formation of features, such as protrusions or cavities, on edges of glass core panels, and following formation complementary features on interior edges of frames, in accordance with some embodiments. The examples in FIGS. 5A-5O are similar in some respects to the example of FIGS. 4A-4F in that the examples may include features that advantageously enforce vertical interlocking of a glass core panel and a frame for a reconstitution process. The examples illustrated in FIGS. 5A-5O include features, such as protrusions and cavities that extend laterally inward or away in (x- or y-dimensions) from edges of a glass core panel.

**FIG. 5A** is a cross-sectional side view illustrating an example glass core panel 504 after formation of one or more protrusions 508 on edges 502 of the glass core panel. FIG. 5B is a cross-sectional side view illustrating an example 524 of the glass core panel 504 after a frame 506 has been formed on the glass core panel (or alternatively after it has been inserted into frame 506). FIG. 5B illustrates a stage of manufacturing after metal 522 has been placed on polymer material 520.

The glass core panel 504 comprises a top surface 510 and a bottom surface 512 opposite the top surface. In addition, the glass core panel 504 comprises edges 502 between the top and bottom surfaces 510, 512. An edge 502 may comprise one or more protrusions 508. Each of the protrusions 508 comprise a first surface 514 parallel to the top surface 510, a second surface 516 opposite first surface 514, and a third surface 518 non-parallel to the top surface, e.g., orthogonal to top surface 510. Like glass core panel 404 and protrusions 408, glass core panel 504 and protrusions 508 have respective thicknesses, and the thickness of the protrusions 508 is less than the thickness of the glass core panel 504. Similar to protrusions 408, protrusions 508 may have a lateral dimension (in the y- or x-dimension) that extends a length of edge 502, or that extends a distance longer or shorter than the length of the edge 502.

Frame 506 comprises a polymer material 520 and metal 522. The polymer material 438 may be placed on edges 502, and on any of the first, second, and third surfaces 514, 516, 518 of protrusions 508. In some examples, metal 522 can be placed on edges 502, on any of the first, second, and third surfaces 514, 516, 518 of protrusions 508, or on polymer material 520. Metal 522 may be the same as metal 440 descried above and polymer material 520 may be the same as polymer material 438 described above.

Except as noted below, the description of glass core panel 504, frame 506 and example 524 with respect to FIGS. 5A-5B applies equally to the examples set forth in FIGS. 5C-5O. Accordingly, the same reference numbers used for certain features in the description of FIGS. 5A-5B are used to describe the same or similar features in the examples of FIGS. 5C-5O.

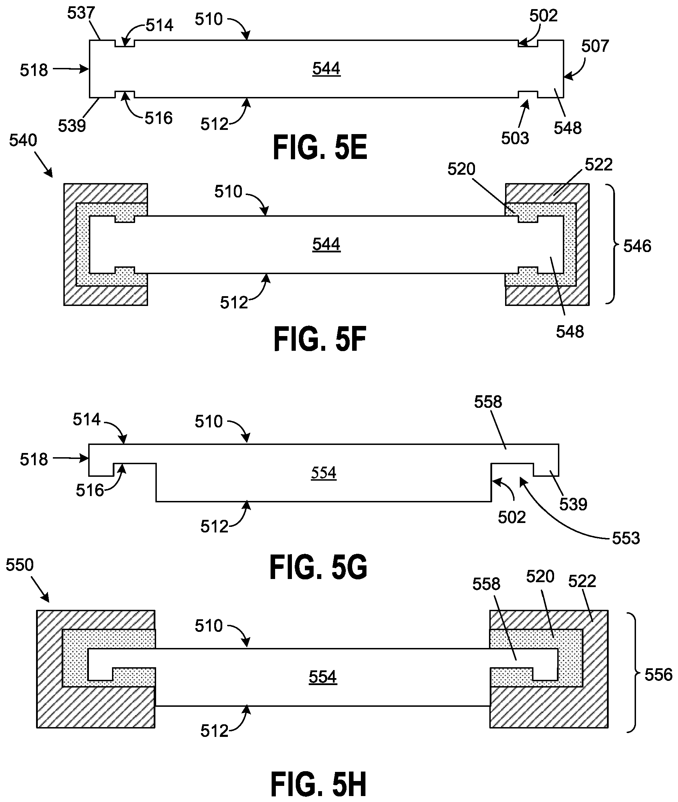

**FIG. 5C** is a cross-sectional side view illustrating an example glass core panel 534 after formation of one or more protrusions 538 on edges 502 of the glass core panel. FIG. 5D is a cross-sectional side view illustrating an example 530 of the glass core panel 534 after a frame 536 has been formed on the glass core panel (or alternatively after it has been inserted into frame 536). FIG. 5D illustrates a stage of manufacturing after metal 522 and polymer material 520 have been placed on protrusions 538. In the illustrated example, protrusions 538 have a "T" shape. In the illustrated example, the "T" of protrusions 538 comprise a first portion or projection 537 on first surface 514 and a second portion or projection 539 on second surface 516. First projection 537 extends away from the first side 514 in a direction perpendicular to the first surface 514. Second projection 539 extends away from the second surface 516 in a direction perpendicular to the second side 516. (The same reference numbers used for in the description of FIGS. 5C-5D to describe the first projection 537 and second projection 539 are used in the examples of FIGS. 5E-5O.)

**FIG. 5E** is a cross-sectional side view illustrating an example glass core panel 544 after formation of one or more grooves 503 near a near a sidewall 507 of the glass core panel. FIG. 5F is a cross-sectional side view illustrating an example 540 of the glass core panel 544 after a frame 546 has been formed on the glass core panel (or alternatively after it has been inserted into frame 546). Sidewall 507 extends between top surface 510 and a bottom surface 512. The grooves 503 may be on protrusions 548 extending laterally from edges 502. FIG. 5F illustrates a stage of manufacturing after polymer material 520 have been placed on protrusions 548. As shown in the figure, polymer material 520 is present in grooves 503. In the illustrated example, protrusions 548 comprise a first portion or projection 537 on first surface 514 and a second portion or projection 539 on second surfaces 516. First projection 537 extends away from the first surface 514 in a direction perpendicular to the first surface 514. Second projection 539 extends away from the second surface 516 in a direction perpendicular to the second surface 516.

**FIG. 5G** is a cross-sectional side view illustrating an example glass core panel 554 after formation of one or more protrusions 558 on edges of the glass core panel. FIG. 5H is a cross-sectional side view illustrating an example 550 of the glass core panel 554 after a frame 556 has been formed on the glass core panel (or alternatively after it has been inserted into frame 556). FIG. 5H illustrates a stage of manufacturing after polymer material 520 have been placed on protrusions 558 and metal 522 has been placed over the polymer material 520. In the illustrated example, protrusions 558 comprise a second portion or projection 539 on second surfaces 516. The second projection 539 extends away from the second surface 516 in a direction perpendicular to the second surface 516 to define a notch or groove 553. In the example illustrated in FIGS. 5G-5H, first surfaces 514 are coplanar with top surface 510, while second surfaces 516 are spaced away from both top surface 510 and bottom surface 512. Second surfaces 516 are parallel with top surface 510.

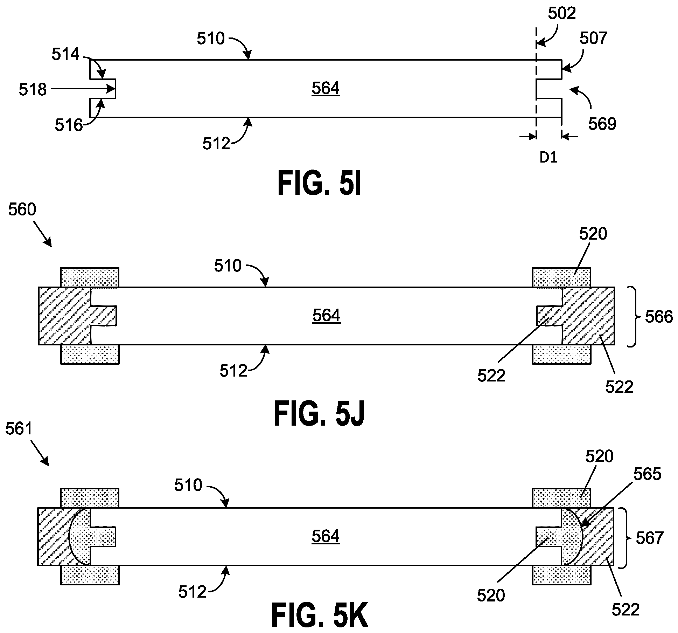

**FIG. 5I** is a cross-sectional side view illustrating an example glass core panel 564 after formation of one or more cavities 569 on sidewalls 507 of the glass core panel. In some examples, each of the cavities 569 comprise a first surface 514 parallel to the top surface 510, a second surface 516 opposite first surface 514, and a third surface 518 non-parallel to the top surface, e.g., orthogonal to top surface 510. In some examples, cavities 569 may extend laterally from third surface 518 at edge 502 to sidewall 507 for a depth D1. The location of edge 502 is shown with a dashed line in FIG. 5I. In other examples, depth D1 may be greater or less than a distance between edge 502 and sidewall 507.

**FIG. 5J** is a cross-sectional side view illustrating an example 560 of the glass core panel 564 after a frame 566 has been formed on the glass core panel (or alternatively after it has been inserted into frame 566). FIG. 5K is a cross-sectional side view illustrating an alternative example 561 of the glass core panel 564 after a frame 567 has been formed on the glass core panel (or alternatively after it has been inserted into frame 567). FIGS. 5J and 5K illustrate stages of manufacturing after metal 522 and polymer material 520 have been placed on the glass core panel 564. As illustrated in example 560, metal 522 may be placed within cavity 569, contacting first surface 514, second surface 516, third surface 518, and sidewall 507. In addition, polymer material 520 may be placed on top and bottom surface 510, 512 and on metal 522.

As illustrated in example 561, polymer material 520 may be placed within cavity 569, contacting first surface 514, second surface 516, third surface 518, and sidewall 507. In example 561, polymer material 520 comprises a surface 565 opposite cavity 569 and opposite sidewall 507. Metal 522 may be placed on surface 565. In addition, polymer material 520 may be placed on top and bottom surface 510, 512 and on metal 522.

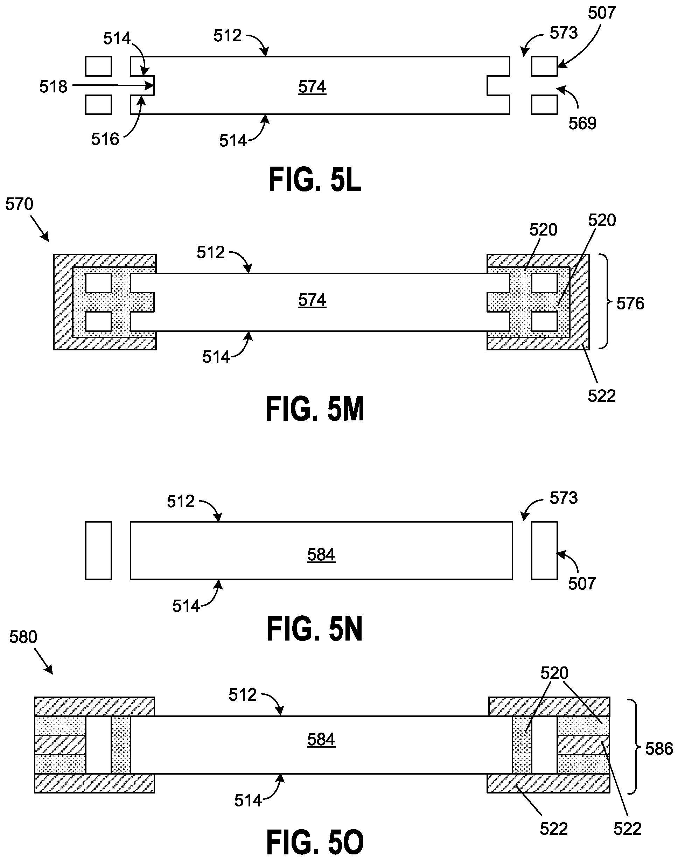

Except as noted herein, cavity 569 depicted in **FIG. 5I-5K** is the same as cavities illustrated in FIGS. 5L-5M. Accordingly, the same reference numbers used to describe cavity 569 are used in the examples of FIGS. 5L-5M.

**FIG. 5L** is a cross-sectional side view illustrating an example glass core panel 574 after formation of one or more cavities 569 on sidewalls 507 of the glass core panel. FIG. 5M is a cross-sectional side view illustrating an example 570 of the glass core panel 574 after a **frame 576** has been formed on the glass core panel (or alternatively after it has been inserted into frame 576). **FIG. 5M** illustrates a stage of manufacturing after polymer material 520 have been placed within hole 573 and within cavity 569, and after metal 522 has been placed over the polymer material 520.

**FIG. 5N** is a cross-sectional side view illustrating an example glass core panel 584 after formation of one or more holes 573 on near sidewalls 507 of the glass core panel. Holes 573 may extend through the glass between top surface 512 and bottom surface 514. FIG. 5M is a cross-sectional side view illustrating an example 580 of the glass core panel 584 after a frame 586 has been formed on the glass core panel (or alternatively after it has been inserted into frame 586). **FIG. 5O** illustrates a stage of manufacturing after polymer material 520 have been placed within hole 573 and over a layer of metal 522 that contacts sidewall 507, and after metal 522 has been placed over the polymer material 520.

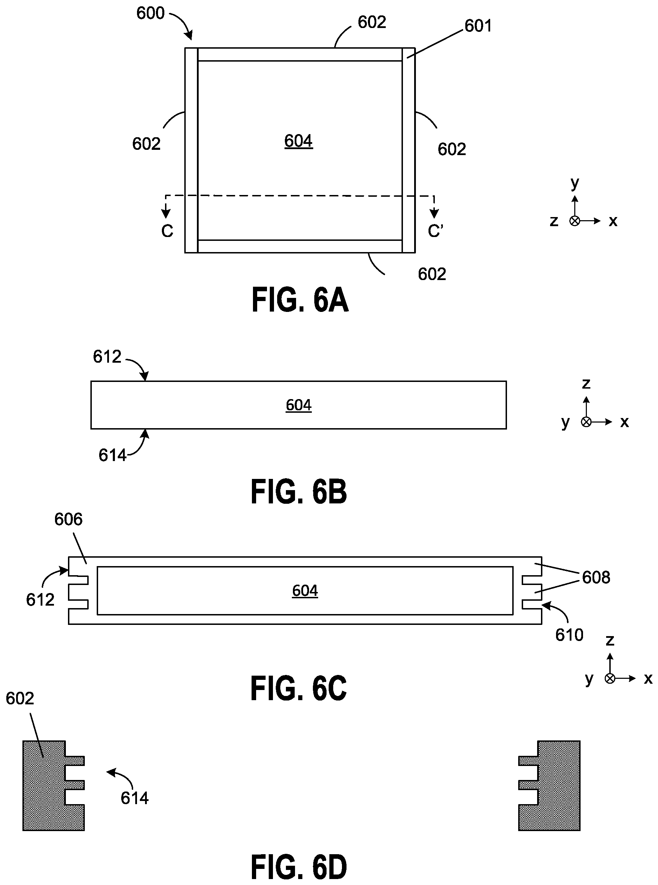

**FIGS. 6A-6F** are plan and cross-sectional side views of a glass core panel 604 reconstituted into a hybrid panel 600 using a reusable frame 601, in accordance with some embodiments. As described above, delamination and other problems can arise when attaching a metal frame to glass. In the example illustrated in FIGS. 6A-6F, glass core panel 604 is encapsulated in a compressible mold material 606 in a reconstitution process prior to further processing during IC package manufacturing. The mold material 606 is textured to fit into a complimentary design on a frame 601. In some examples, frame 601 is comprised of metal and is reusable. In other examples, frame 601 may be comprised of organic materials. Chemical mechanical polishing (CMP) may be used to polish away mold material 606 to expose the top and bottom surface 612, 614 of the glass core panel 604 for processing. Advantages of using a metal frame rather than an organic frame are that larger glass core panels can be used and higher temperatures can be used in processing. An organic frame is typically only used one time. A further advantage of reusable metal frames is less wasted material and cost. Another advantage of hybrid panel 600 is that mold material 606 may act as a shock absorber around the glass core panel 604. In examples, the CTE of the glass core panel is in the range of 1-8 ppm/°C. In examples, the mold material 606 also has a CTE in the range of 1-8 ppm/°C. In examples, mold material 606 comprises an epoxy, and may comprise multi-aromatic resins (MAR), biphenyl, and cresol novolac epoxy resins.

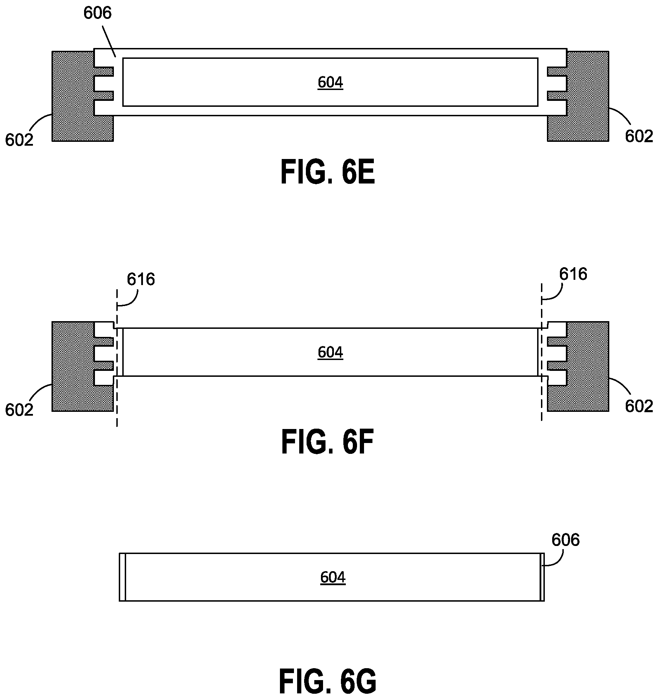

**FIG. 6A** illustrates example hybrid panel 600 that comprises a frame 601 and a glass core panel 604. The frame 601 comprises frame side members 602. FIGS. 6B-6G are cross-sectional sides view taken along line C-C' of FIG. 6A. As illustrated in **FIG. 6B****,** the glass core panel 404 comprises a top surface 422 and a bottom surface 421 opposite the top surface. **FIG. 6C** illustrates the glass core panel 404 after it has been encapsulated in mold material 606 and after protrusions 608 and/or cavities 610 have been formed on edges or sidewalls 612 of the mold material. The features on sidewalls 612, i.e., protrusions 608 and cavities 610, may be complements of features 614 on frame side members 602. **FIG. 6D** illustrates features 614 on frame side members 602. **FIG. 6E** illustrates the encapsulated glass core panel 404 after it has been placed in frame 601. As illustrated in **FIG. 6E****,** the features 614 on sidewalls 612 may fit into the complimentary features 614. Embodiments are not limited to the protrusions 608 and cavities 610 on sidewalls 612 of the mold material 606 and complimentary features 614 frame 601. The features on the mold material 606 and frame 601 may take any suitable shape. In various examples, features on the mold material 606 and frame 601 may be formed in any of the shapes described elsewhere herein. **FIG. 6F** illustrates the encapsulated glass core panel 404 and frame side members 602 after a CMP operation. Vertical dashed line 616 depict a possible location for a singulation operation. **FIG. 6F** illustrates the encapsulated glass core panel 404 and frame side members 602 after singulation. As illustrated in **FIG. 6G****,** part of the mold material 606 may be left on the edge of the singulated glass units.

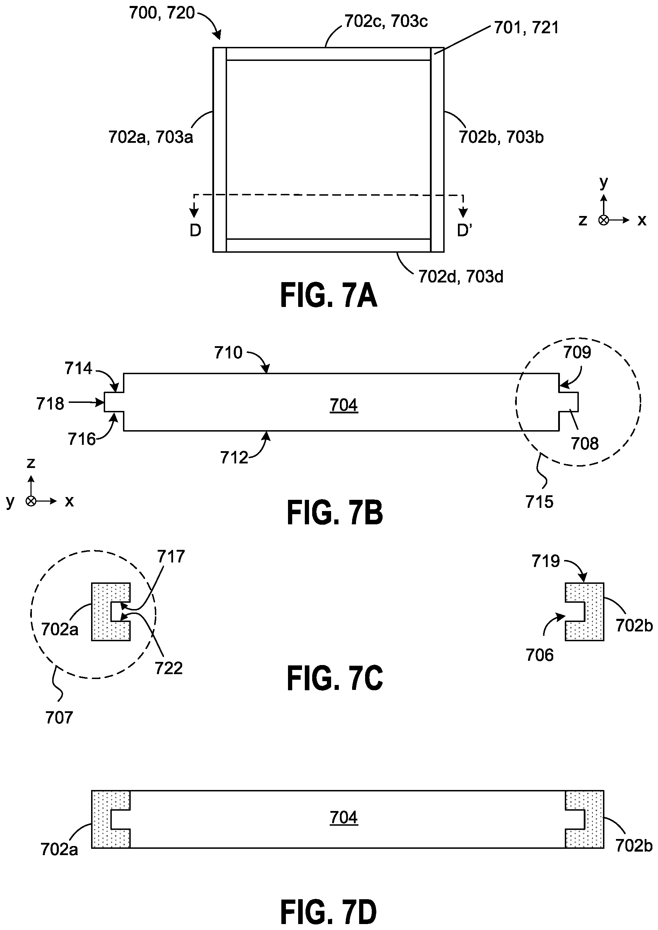

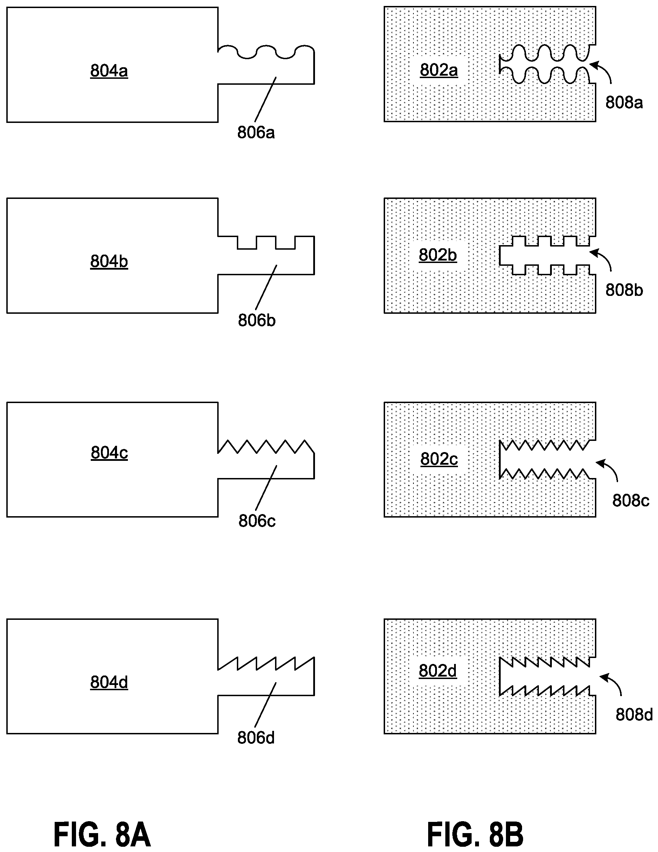

**FIGS. 7A-7G** are plan and cross-sectional side views of glass core panels and frames comprising projections or cavities integrated into the glass core panels and frames, in accordance with some embodiments. These projections and cavities comprise surfaces. **FIGS. 8A-8D** are enlarged cross-sectional side views of features on the surfaces of the projections and cavities of the glass core panels and frames illustrated in **FIGS. 7A-7G****,** in accordance with some embodiments.

As noted, glass core panels can be damaged from handling during manufacturing of IC packages. While a mold material and other organic (dielectric) materials may be applied around a glass core panel to provide protection, adhesion of these materials to glass can be challenging. The surface of the glass can be smooth or chemically incompatible with the organic material. In some examples, wings or projections are integrated into edges or sidewalls of a glass core panel to improve mold adhesion. In other examples, pockets or cavities are integrated into edges or sidewalls of a glass core panel to improve mold adhesion. In examples, one or more surfaces of the wings or pockets (projections or cavities) of a glass core panel comprise ridges, teeth, fins, through holes, and other features for additional mechanical adhesion. In examples, one or more surfaces of the wings or pockets (projections or cavities) of a glass core are roughned using a laser or chemical treatment.

In some embodiments, wings or projections are integrated into an interior edge or sidewall of a frame. These wings or projections (projections or cavities) comprise sizes and shapes that mate with complementar protrusions or cavities of a glass core panel. In examples, one or more surfaces of the wings or pockets (projections or cavities) of a frame comprise ridges, teeth, fins, through holes, and other features for additional mechanical adhesion. In examples, one or more surfaces of the wings or pockets (projections or cavities) of a frame are roughned using a laser or chemical treatment.

The surface features of a glass core panel or a frame may comprise regular shapes or repeating pattern of shapes, such as sawtooth, triangle, square, jagged, or sine wave patterns. In some examples, e.g., where the surface features of a glass core panel or a frame are a regular or repeating pattern of shapes, the surface features may have a size in a range of about 100 µm to 500 µm. In some examples, the surface features of a glass core panel or a frame have a height perpendicular to a surface of between 100 µm to 500 µm. In some examples, the surface of a glass core panel or a frame is micro roughened, and the surface features may be irregular. In some examples, a surface of a glass core panel or a frame comprises an average surface roughness of between 1 µm to 10 µm. Micro-roughened surfaces or surfaces with larger tooth-like features may be fabricated with a laser or wet etch processes. The wings or pockets (projections or cavities) can be integrated at the full glass panel, quarter panel, or unit level of a glass core panel or frame. Advantageously, the wings and pockets, and the features on the wings and pockets, provide more surface area for mechanical adhesion to between the glass and the organic material.

**FIG. 7A** illustrates example hybrid panel 700 that comprises a frame 701 to receive a glass core panel 704. **FIG. 7B** is a cross-sectional side view taken along line D-D' of FIG. 7A. The frame 701 comprises frame side members 702a, 702b, 702c, and 702d. The glass core panel 704 comprises a top surface 710 and a bottom surface 712 opposite the top surface. The glass core panel 704 comprises edges 709 between the top and bottom surfaces 710, 712. An edge 709 may comprise one or more protrusions 708. Each of the protrusions 708 comprise a first surface 714 parallel to the top surface 710, a second surface 716 opposite first surface 714, and a third surface 718 non-parallel to the top surface, e.g., orthogonal to top surface 710. Circled area 715 encloses protrusion 708. **FIG. 8A** illustrates enlarged views of circled area 715.

**FIG. 7C** is a cross-sectional side view of frame 701 taken along line D-D' prior to insertion of glass core panel 704. Frame side member 702a comprises a cavity 706. The cavity 706 comprises a fourth surface 717 parallel to an upper surface 719 of frame 701. The cavity 706 also comprises a fifth surface 722 parallel to the upper surface 719 and facing fourth surface 717. Circled area 707 encloses cavity 706. **FIG. 8B** illustrates enlarged views of circled area 707. **FIG. 7D** is a cross-sectional side view of frame 701 taken along line D-D' after insertion of glass core panel 704.

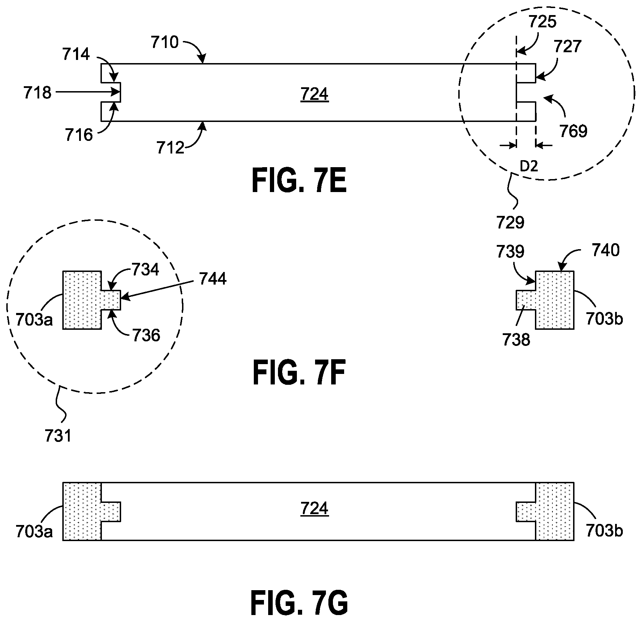

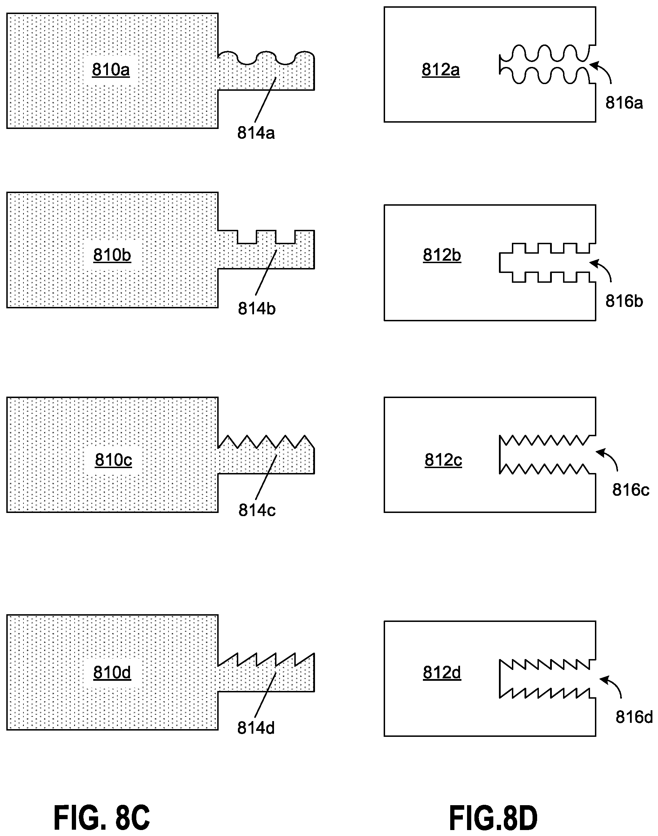

**FIG. 7A** also illustrates example hybrid panel 720 that comprises a frame 721 to receive a glass core panel 724. **FIG. 7B** is a cross-sectional side view taken along line D-D' of FIG. 7A. The frame 721 comprises frame side members 703a, 703b, 703c, and 703d. The glass core panel 724 comprises a top surface 710 and a bottom surface 712 opposite the top surface. Referring to **FIG. 7E****,** an example glass core panel 724 comprises one or more cavities 769 on sidewalls 727 of the glass core panel. In some examples, each of the cavities 769 comprise a first surface 714 parallel to the top surface 710, a second surface 716 opposite first surface 714, and a third surface 718 non-parallel to the top surface, e.g., orthogonal to top surface 710. In some examples, cavities 769 may extend laterally from third surface 718 at an edge 725 to sidewall 727 for a depth D2. The location of edge 725 of glass core panel 724 is shown with a dashed line in FIG. 7E. In other examples, depth D2 may be greater or less than a distance between edge 725 and sidewall 727. Circled area 729 encloses cavity 769. **FIG. 8D** illustrates enlarged views of circled area 729.

**FIG. 7F** is a cross-sectional side view of frame 721 taken along line D-D'. The frame 721 comprises one or more protrusions 738 on an interior edge or sidewall 739 of the frame. Each of the protrusions 738 comprise a first surface 734 parallel to an upper surface 740 of the frame, a second surface 736 opposite first surface 734, and a third surface 744 non-parallel to the upper surface 740, e.g., orthogonal to upper surface 740. Circled area 731 encloses protrusion 738. **FIG. 8C** illustrates enlarged views of circled area 731. **FIG. 7G** is a cross-sectional side view of frame 721 taken along line D-D' after insertion of glass core panel 724.

**FIG. 8A** illustrates enlarged cross-sectional side views of protrusions on the edge of the glass core panel in circled area 715 of FIG. 7B, in accordance with some embodiments. The glass core panels 804a, 804b, 804c, and 804d correspond with glass core panel 704. The protrusions 806a, 806b, 806c, and 806d correspond with protrusion 708. Sinewave features are on a surface corresponding with surface 714 on protrusion 806a. Square features on a surface corresponding with surface 714 on protrusion 806b. Triangle features on a surface corresponding with surface 714 on protrusion 806c. Sawtooth features on a surface corresponding with surface 714 on protrusion 806a.

**FIG. 8B** illustrates enlarged cross-sectional side views of cavities on the edge of the frame in circled area 707 of FIG. 7C, in accordance with some embodiments. The frame side members 802a, 802b, 802c, and 802d correspond with side member 702a. The cavities 808a, 808b, 808c, and 808d correspond with cavity 706. Sinewave features are on surfaces corresponding with surfaces 717, 718 in cavity 808a. Square features are on surfaces corresponding with surfaces 717, 718 in cavity 808b. Triangle features are on surfaces corresponding with surfaces 717, 718 in cavity 808c. Sawtooth features are on surfaces corresponding with surfaces 717, 718 in cavity 808d.

**FIG. 8C** illustrates enlarged cross-sectional side views of protrusions on the edge of the frame in circled area 731 of FIG. 7F, in accordance with some embodiments. The frame side members 810a, 810b, 810c, and 810d correspond with frame side member 703a. The protrusions 814a, 814b, 814c, and 814d correspond with protrusion 738. Sinewave features are on a surface corresponding with surface 734 on protrusion 814a. Square features on a surface corresponding with surface 734 on protrusion 806b. Triangle features on a surface corresponding with surface 734 on protrusion 806c. Sawtooth features on a surface corresponding with surface 734 on protrusion 806a.

**FIG. 8B** illustrates enlarged cross-sectional side views of cavities on the edge of the glass core panel in circled area 729 of FIG. 7E, in accordance with some embodiments. The glass core panels 812a, 812b, 812c, and 812d correspond with glass core panel 724. The cavities 816a, 816b, 816c, and 816d correspond with cavity 769. Sinewave features are on surfaces corresponding with surfaces 714, 716 in cavity 816a. Square features are on surfaces corresponding with surfaces 714, 716 in cavity 816b. Triangle features are on surfaces corresponding with surfaces 714, 716 in cavity 816c. Sawtooth features are on surfaces corresponding with surfaces 714, 716 in cavity 816d.

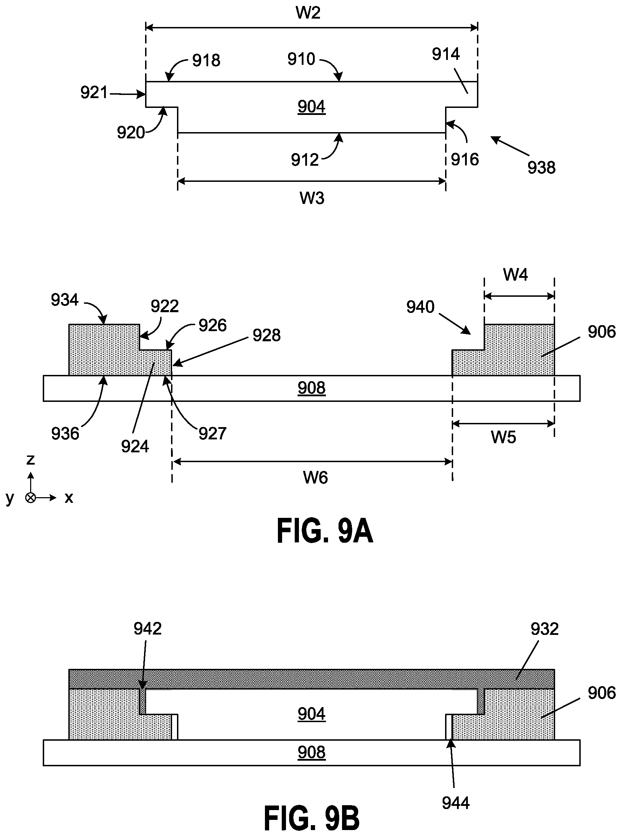

**FIGS. 9A-9E** illustrate cross-sectional side views of stages of manufacturing a hybrid glass core panel using a step-in frame, in accordance with some embodiments. When embedding a glass core panel in a frame comprised of CCL or organic materials, one problem that can arise is that the frame is not strong or stiff enough to hold the glass core well. Using a step-in frame when reconstituting a glass core panel may advantageously increase the strength, stiffness, or both the strength and stiffness of the hybrid panel.

**FIG. 9A** illustrates a cross-sectional side view of a glass core panel and a frame prior to being inserted into a frame. Glass core panel 904 comprises protrusions 914 on edges 916 of the glass core panel. The glass core panel 904 includes a top surface 910 and a bottom surface 912, with edges 916 extending between the top and bottom surfaces. Protrusions 914 comprise a first surface 918 parallel to the top surface 910, a second surface 920 opposite first surface 918, and a third surface 921 non-parallel to the top surface, e.g., orthogonal to top surface 910. In the example illustrated in FIG. 9A, first surface 918 of protrusion 914 is coplanar with top surface 910, and second surface 920 is spaced away from bottom surface 912 to define an inverted (in the orientation depicted in FIG. 9A) step 938. Glass core panel 904 comprises a width W2 at top surface 910 and a width W3 at bottom surface 912. Width W2 is greater than width W3, and the difference between W2 and W3 defines a width of the inverted step 938.

The frame 906 comprises an upper surface 934, a lower surface 936, and an interior edge 922 between the upper and lower surfaces 934, 936. A protrusion 924 extends from the interior edge 922. The protrusion 924 comprises a fourth surface 926 parallel to the upper surface 934, a fifth surface 927 opposite the fourth surface, and sixth surface 928 non-parallel to the upper surface, e.g., orthogonal to upper surface 934. In the example illustrated in FIG. 9A, fifth surface 927 of protrusion 924 is coplanar with lower surface 936, and fourth surface 926 is spaced away from upper surface 934 to define a step 940 (or ledge). Frame 906 comprises a width W4 at upper surface 934 and a width W5 at lower surface 936. Width W5 is greater than width W4, and the difference between W5 and W4 defines a width of the step 940. The frame 906 includes a width W6 between sixth surfaces 928 on protrusions 924.

The frame 906 is on a stage or carrier 908. In embodiments, stage or carrier 908 may be reusable. Frame 906 may be attached to the carrier with a releasable film e.g., temporary bond film (TBF), laser release film, or similar films. The frame 906 may comprise CCL, mold material, metal, or a combination of these materials.

**FIG. 9B** illustrates a cross-sectional side view of the glass core panel 904 and frame 906 after the panel has been inserted into the frame, and after a mold material has been applied to the top side 910 and upper surface 934, in accordance with some embodiments. In examples, mold material 932 covers the top side 910 and upper surface 934. In addition, mold material 932 fills gaps 942 between the glass core panel 904 and frame 906 and may contact fourth surface 926. After insertion of the glass core panel 904 into the frame, there are also gaps 944 between edges 916 and sixth surface 928. The width of gaps 944 equal to the difference between width W6 and width W3. In some embodiments, the width of gaps 942 and 944 is between about 500µm-0.01mm.

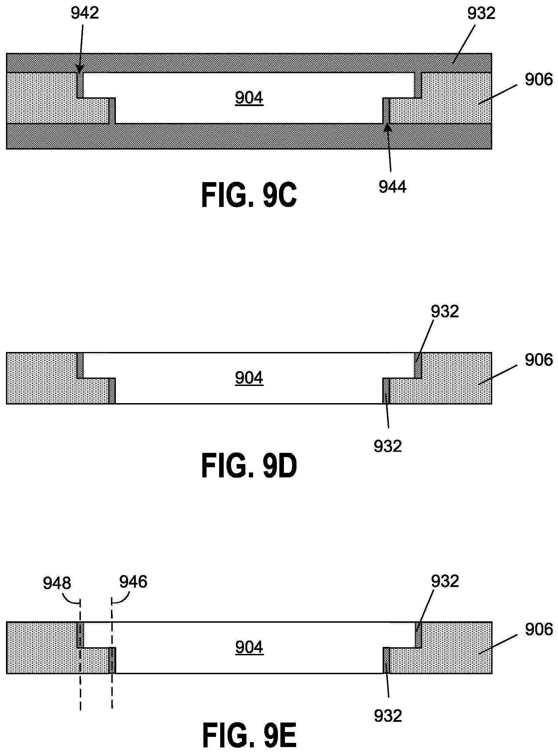

**FIG. 9C** illustrates a cross-sectional side view of the glass core panel 904 after the carrier 908 has been removed and mold material 932 has been applied to the bottom surface 912 of the panel and the lower surface 936 of the frame. In examples, mold material 932 covers bottom surface 912, lower surface 936, and fills gap 944. In some embodiments, mold material 932 may contact second surface 920. **FIG. 9D** illustrates a cross-sectional side view of the glass core panel and frame after the mold has been planarized with the top and bottom surfaces of the frame. In some examples, the mold material 932 may be retained on the top surface, bottom surface, or on both the top and bottom surfaces to be used as a build-up layers. In some examples, stiffeners, e.g., pre-preg material, can be added over the frame, if needed. The example in FIG. 9D can be used in subsequent stage of manufacturing an IC package, such as adding build up layers.

**FIG. 9E** illustrates a cross-sectional side view of the glass core panel and frame illustrated in FIG. 9D showing possible singulation locations. In embodiments where carrier 908 is to be reused, singulation may occur along dashed line 946. After singulation along dashed line 946, mold material 932 may remain on edges 916 of the glass core panel 904. In other embodiments, singulation may occur along dashed line 948. After singulation along dashed line 948, mold material main remain on edges 916 and third surface 921 of the glass core panel 904.

As noted, existing tools for manufacture of IC packages were not developed to handle glass core panels and the brittle nature of glass makes glass core panels susceptible to chipping, cracking or breaking when the panels are processed using existing tools designed for organic cores. Embedding a glass core panel into an organic frame via reconstitution process can isolate and protect edges of the glass core panel edges from direct contact with tools. However, there is risk of cracking or debonding at the interface of the glass core panel and the organic frame. Embodiments advantageously strengthen the bond between the glass core panel the organic frame by providing a series of slots in a frame and tabs in a glass core panel. The slots and tabs interlock with each other to provide mechanical anchoring, requiring higher debonding forces than required to debond glass core panels embedded without the slots and tabs.

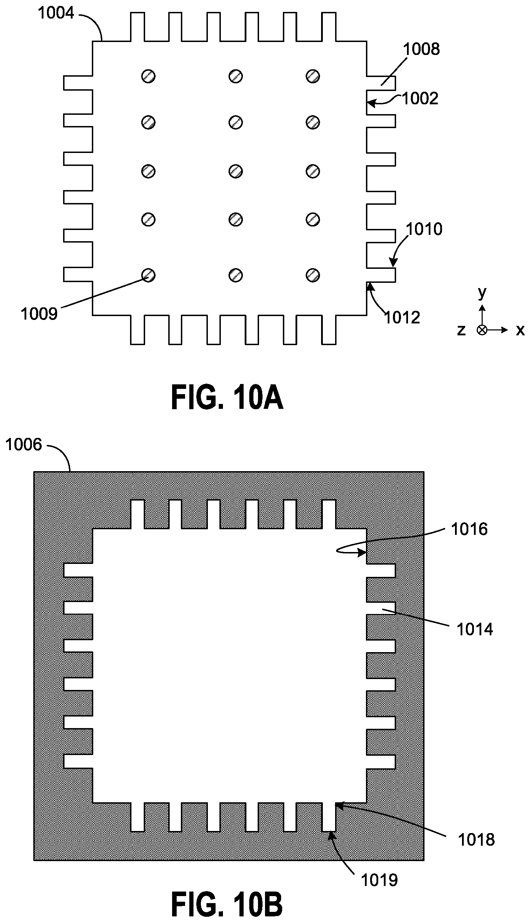

**FIGS. 10A-10G** are plan and cross-sectional side views of a glass core panel with tabs or protrusions and a frame with complementary slots or cavities evolving through several stages of manufacturing, in accordance with some embodiments. While the examples presented in FIGS. 10A-10G illustrate protrusions that are tab shaped and cavities that are slot shaped, the protrusions and cavities can be formed in a variety of other shapes as described elsewhere herein, e.g., glass core panels 304, 326, 336, 346, and 356, and frames 306, 328, 338, 348, and 358.

**FIGS. 10A-10B** are plan views of glass core panels and frames following formation of tabs or protrusions on the glass core panels, and following formation of a plurality of slot or cavities on the frames, in accordance with some embodiments. FIGS. **10A-10B** illustrates the contours of the protrusions and cavities in the x-y dimensions - these contours are edges of the features that may extend through a thickness of the glass or frame in a z-direction substantially orthogonal to a surface of the glass panel or frame. The protrusions and cavities comprise complementary shapes that interlock in the x-y dimensions.

**FIG. 10A** illustrates an example glass core panel 1004 after formation of a plurality of tabs or protrusions 1008 on sidewalls 1002. Tabs or protrusions 1008 comprise a proximal end 1012 at an edge or sidewall 1002 of glass core panel 1004 and a distal portion 1010 away from where the protrusion connects to the glass at the sidewall. The glass core panel 1004 may have plurality of through-glass vias (TGV) 1009 that comprise a conductive material, such as copper.

**FIG. 10B** illustrates an example frame 1006. Frame 1006 has an interior sidewall 1016 comprising a plurality of slots or cavities 1014, each shaped to mate with one of the plurality of protrusions 1008. A shape of a tab or protrusion 1008 on a glass core panel sidewall and a shape of a slot or cavity 1014 on an interior sidewall of a frame may be complements. For example, a slot or cavity 1014 includes a first end 1018 at interior sidewall 1016 and a second end 1019 opposite first end 1018. Like protrusions 1008, cavities 1014 may extend through a thickness of the frame in a z-direction substantially orthogonal to a surface of the frame.

While the shape of a protrusion 1008 and a shape of a cavity 1014 may be complements, the cavity may be slightly larger than the protrusion to facilitate insertion of the protrusion in the cavity and/or as a result of manufacturing variations. Accordingly, there may be one or more small gaps (not illustrated in the figures) between a protrusion 1008 and a cavity 1014 along thickness of the glass or frame in a z-direction.

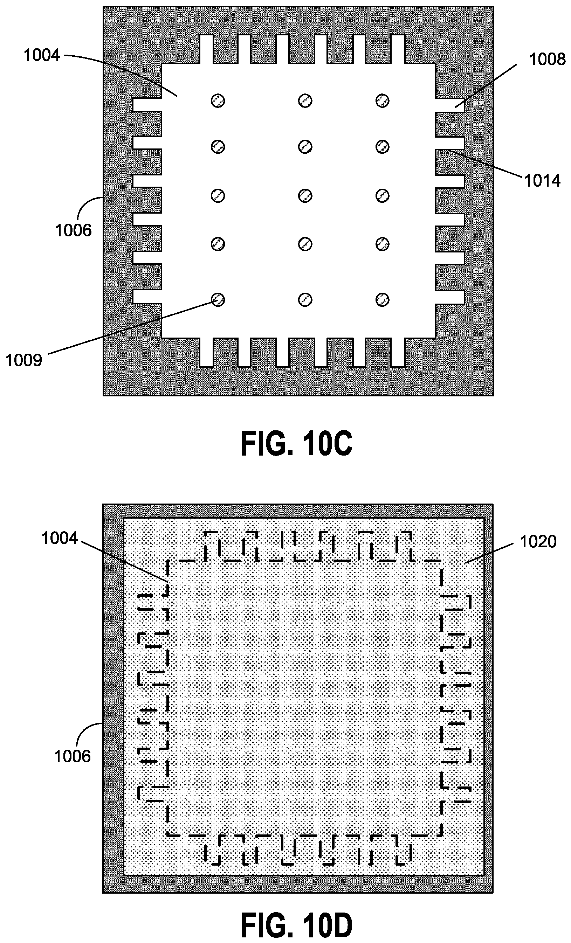

**FIG. 10C** illustrates the glass core panel 1004 after it has been inserted into frame 1006. In various embodiments, frame 1006 may comprise polymer material, a metal, or other frame material described herein. After a glass core panel 1004 has been inserted into frame 1006, portions of the frame 1006 are between (in the y- or x- direction) first and second adjacent protrusions 1008 of the glass core panel 1004. Accordingly, in some examples, a glass core hybrid panel comprises a polymer material, a metal, or other frame material between first and second adjacent protrusions 1008.

**FIG. 10D** illustrates frame 1006 after a mold 1020 or polymer material has been formed over a surface of a glass core panel 1004 within a frame during a manufacturing operation. The location of the peripheral edges of glass core panel 1004 are shown with a dashed line. In some examples, the mold 1020 or polymer material may be in a gap between the frame and the glass core panel in addition to over the surfaces.

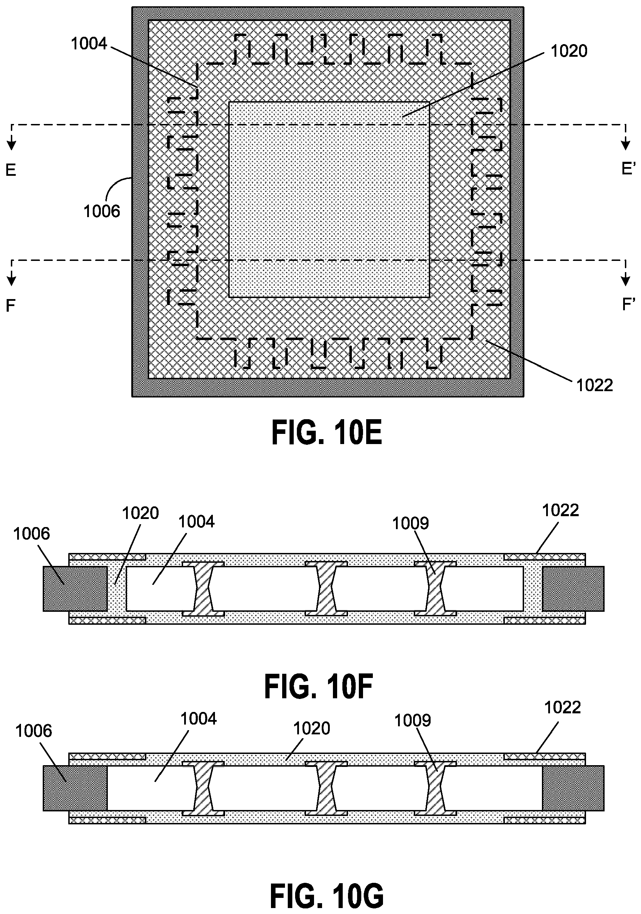

**FIG. 10E** illustrates frame 1006 and mold 1020 after a reinforcing material 1022 has been placed over mold 1020. In some examples, reinforcing material 1022 comprises copper or pre-preg material. **FIG. 10F** is a cross-sectional side view of the assembly in **FIG. 10E** taken along line E-E'. As illustrated in FIG. **10F****,** mold 1020 is between sidewalls 1002 of glass core panel 1004 and frame 1006 in locations between protrusions 1008. **FIG. 10G** is a cross-sectional side view of the assembly in **FIG. 10E** taken along line F-F'. As illustrated in FIG. **10G****,** sidewalls 1002 of glass core panel 1004 may contact frame 1006 in locations with protrusions 1008.

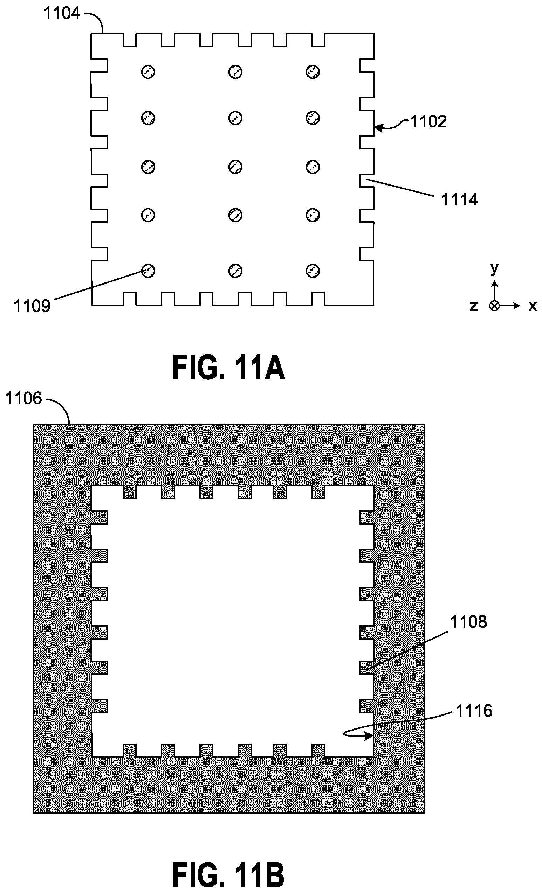

**FIGS. 10A-10G** illustrate an example of a glass core panel with a series of tabs or protrusions and an organic frame with a series of slots or cavities to receive the tabs. In contrast, **FIGS. 11A-11E** illustrate plan views of an organic frame with a series of tabs or protrusions and a glass core panel with a series of slots or cavities to receive the tabs evolving through several stages of manufacturing, in accordance with some embodiments.

**FIG. 11A** illustrates an example glass core panel 1104 after formation of a plurality of slots or cavities 1114 on sidewalls or edges 1102. The glass core panel 1104 may have plurality of TGVs 1109 that comprise a conductive material, such as copper. **FIG. 11B** illustrates an example frame 1106 comprising an interior sidewall 1116 and a plurality of tabs or protrusions 1108, each shaped to mate with one of the plurality of cavities 1114. The protrusions 1108 and cavities 1114 may extend through a thickness of the frame in a z-direction substantially orthogonal to a surface of the frame.

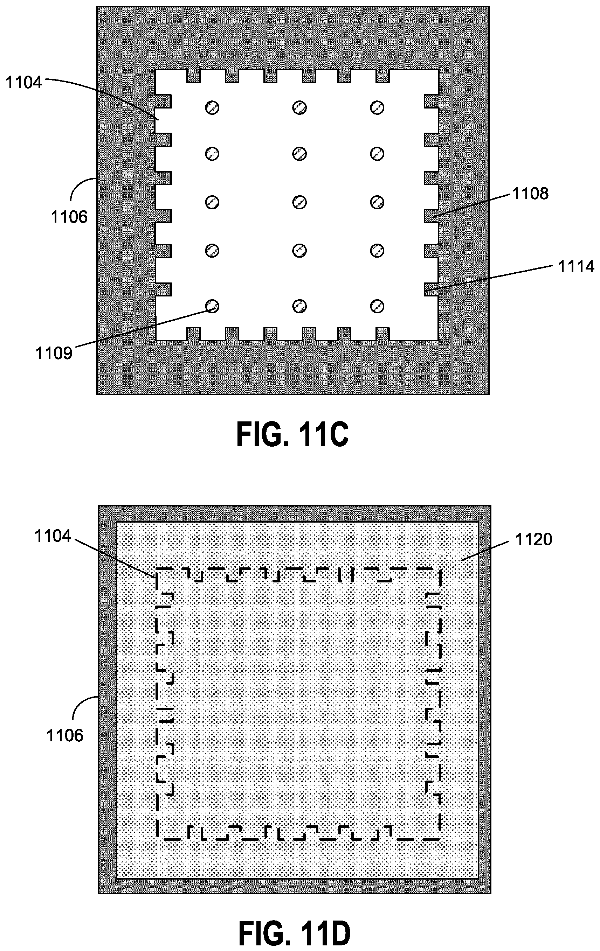

**FIG. 11C** illustrates the glass core panel 1104 after it has been inserted into frame 1106. In various embodiments, frame 1106 may comprise polymer material, a metal, or other frame material described herein. After a glass core panel 1104 has been inserted into frame 1106, portions of the frame 1106 are between (in the y- or x- direction) first and second adjacent cavities 1114 of the glass core panel 1004. Accordingly, in some examples, a glass core hybrid panel comprises a polymer material, a metal, or other frame material between first and second adjacent cavities 1114.

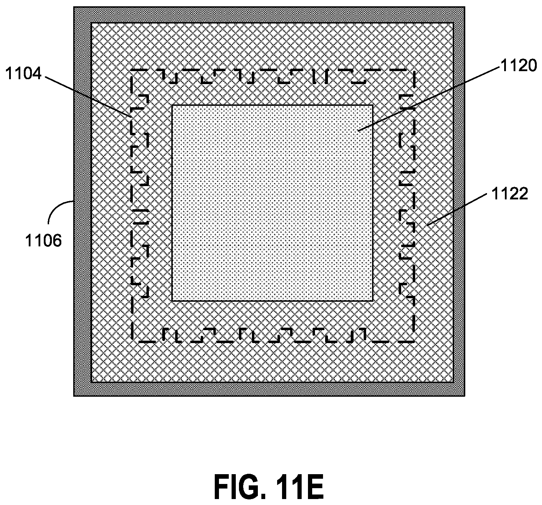

**FIG. 11D** illustrates frame 1106 after a mold 1120 or polymer material has been formed over a surface of a glass core panel 1104 within the frame 1106 during a manufacturing operation. The location of the peripheral edges of glass core panel 1104 are shown with a dashed line. In some examples, the mold 1120 or polymer material may be in a gap between the frame and the glass core panel in addition to over the surfaces. **FIG. 11E** illustrates frame 1106 and mold 1120 after a reinforcing material 1122 has been placed over mold 1120. In some examples, reinforcing material 1122 comprises copper or pre-preg material.

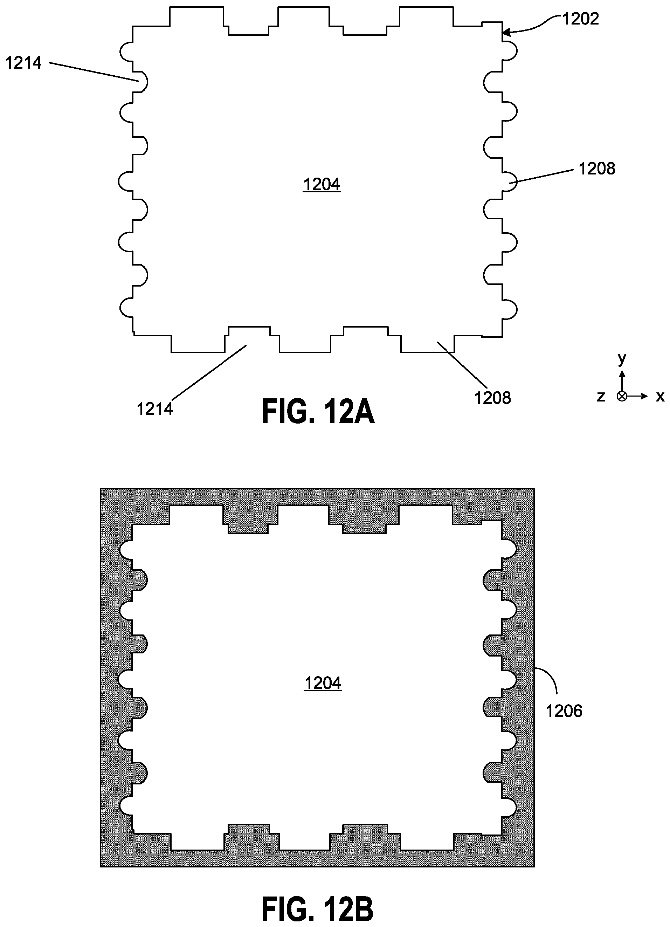

**FIGS. 12A-12B** are plan views of glass core panels and frames following formation of sidewall protrusions on the glass core panels, and following formation of a plurality of cavities on the frames, in accordance with some embodiments. As can be seen in the examples, the protrusions can have a variety of shapes and each cavity comprises a shape to mate with a corresponding protrusion. **FIGS. 12A-12B** illustrate the contours of the protrusions and cavities in the x-y dimensions - these contours are edges of the features that may extend through a thickness of the glass or frame in a z-direction substantially orthogonal to a surface of the glass panel or frame. The protrusions and cavities comprise complementary shapes that interlock in the x-y dimensions.

**FIG. 12A** illustrates an example glass core panel 1204 after formation of a plurality of protrusions 1208 and cavities 1214 on sidewalls 1202. Protrusions 1208 may include shapes with a curved or straight perimeters. Cavities 1214 may include shapes with a curved or straight perimeters. **FIG. 12B** illustrates an example of glass core panel 1204 after it has been inserted into frame 1206. Frame 1206 comprises protrusions and cavities that have shapes in the x, y dimensions that complement the shapes of protrusions 1208 and cavities 1214. The protrusions and cavities of frame 1206 may extend through a thickness of the frame in a z-direction substantially orthogonal to a surface of the frame. A polymer material, e.g., mold, may be formed over a surface of a glass core panel 1204 within frame 1206 in a manufacturing operation. In some examples, the polymer material may be in a gap between the frame and the glass core panel. While particular example shapes of protrusions and cavities are shown in **FIGS. 12A-12B****,** the protrusions and cavities can be formed in a variety of other shapes as described elsewhere herein.

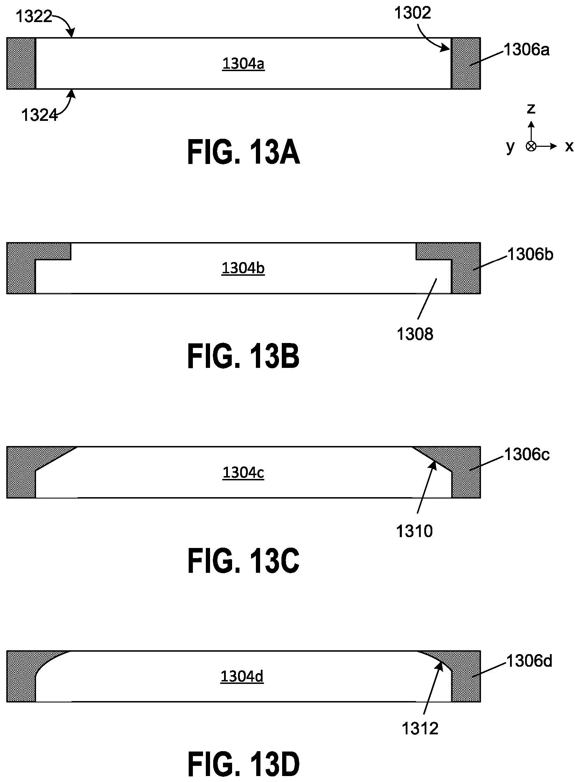

**FIGS. 13A-13H** are cross-sectional side views of a glass core panel following formation of protrusions and corner features on edges of a glass core panel, and following formation complementary features on interior edges of a frame, in accordance with some embodiments. FIGS. 13A-13H illustrate examples of protrusions that extend laterally (in x- or y-dimensions) at edges or sidewalls of a glass core panel. Advantageously, the protrusions and corner features enforce vertical interlocking of a glass core panel and a frame for a reconstitution process.

**FIG. 13A** illustrates an example glass core panel 1304a after the glass core panel has been inserted in a frame 1306a. Glass core panels 1304a, 1304b, 1304c, and 1304d comprise a top surface 1322 and a bottom surface 1324 opposite the top surface. In addition, the glass core panels 1304a, 1304b, 1304c, and 1304d comprises edges or sidewalls 1302 between the top and bottom surfaces 1322, 1324.

**FIG. 13B** illustrates an example glass core panel 1304b after the glass core panel has been inserted in a frame 1306b. Glass core panel 1304b comprises a protrusion 1308 at edge 1302 and frame 1306b comprises a complementary feature to receive the protrusion. The protrusion includes a surface coplanar with bottom surface 1324.

**FIG. 13C** illustrates an example glass core panel 1304c after the glass core panel has been inserted in a frame 1306c. Glass core panel 1304c comprises an edge feature 1310 where top surface 1322 meets edge 1302. Edge feature 1310 may comprise a flat surface that makes angles with top surface 1322 and edge 1302. Edge feature 1310 may be a beveled surface. Edge 1302 may include a straight surface orthogonal to top surface 1322 in addition to beveled edge 1310. Frame 1306c comprises a complementary feature to receive beveled edge 1310.

**FIG. 13D** illustrates an example glass core panel 1304d after the glass core panel has been inserted in a frame 1306d. Glass core panel 1304d comprises an edge feature 1312 where top surface 1322 meets edge 1302. Edge feature 1312 may comprise a convex rounded surface between top surface 1322 and edge 1302. Edge feature 1312 may comprise a suitable radius of curvature. Edge 1302 may include a straight surface orthogonal to top surface 1322 in addition to edge feature 1312 with a convex rounded shape. Frame 1306d comprises a complementary feature to receive edge feature 1312.

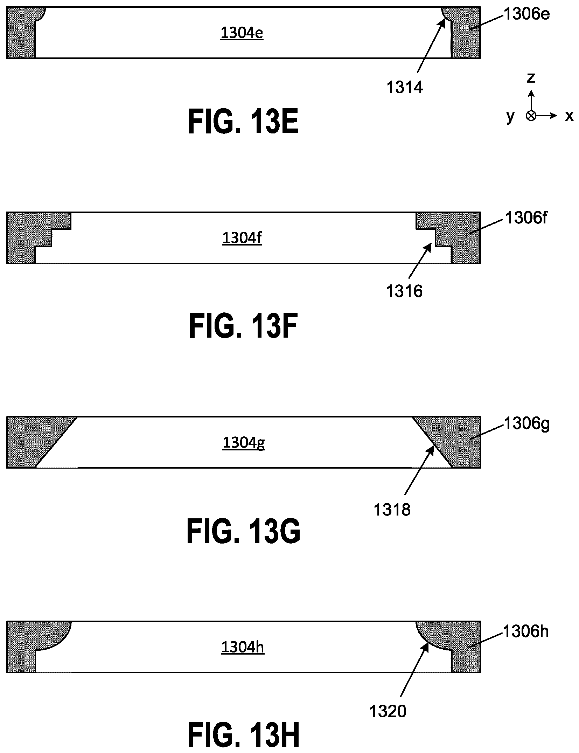

**FIG. 13E** illustrates an example glass core panel 1304e after the glass core panel has been inserted in a frame 1306e. Glass core panel 1304e comprises an edge feature 1314 where top surface 1322 meets edge 1302. Edge feature 1314 may comprise a concave rounded surface between top surface 1322 and edge 1302. Edge feature 1314 may comprise a suitable radius of curvature. Edge 1302 may include a straight surface orthogonal to top surface 1322 in addition to edge feature 1314 with a concave rounded surface. Frame 1306e comprises a complementary feature to edge feature 1314.

**FIG. 13F** illustrates an example glass core panel 1304f after the glass core panel has been inserted in a frame 1306f. Glass core panel 1304f comprises an edge feature 1316 that comprises the entire edge 1302. Edge feature 1316 comprises a plurality of protrusions that together form a stairstep shape. Individual protrusions within the plurality of protrusions are similar to protrusions described elsewhere herein, e.g., protrusion 1308, protrusion 914. Frame 1306f comprises a complementary feature to receive edge feature 1316 with a stairstep shape.

**FIG. 13G** illustrates an example glass core panel 1304g after the glass core panel has been inserted in a frame 1306g. Glass core panel 1304g comprises an edge feature 1318 that comprises the entire edge 1302. Edge feature 1318 may be a beveled surface. Edge feature 1318 may be a flat surface that extends between and makes angles with top surface 1322 and bottom surface 1324. Frame 1306g comprises a complementary feature to receive edge feature 1318.

**FIG. 13H** illustrates an example glass core panel 1304h after the glass core panel has been inserted in a frame 1306h. Glass core panel 1304h comprises an edge feature 1320 where top surface 1322 meets edge 1302. Edge feature 1320 may comprise a concave rounded surface between top surface 1322 and edge 1302. Edge feature 1320 may comprise a suitable radius of curvature. Edge 1302 may include a straight surface orthogonal to top surface 1322 in addition to edge feature 1320 with a concave rounded surface. Frame 1306e comprises a complementary feature to receive edge feature 1320.

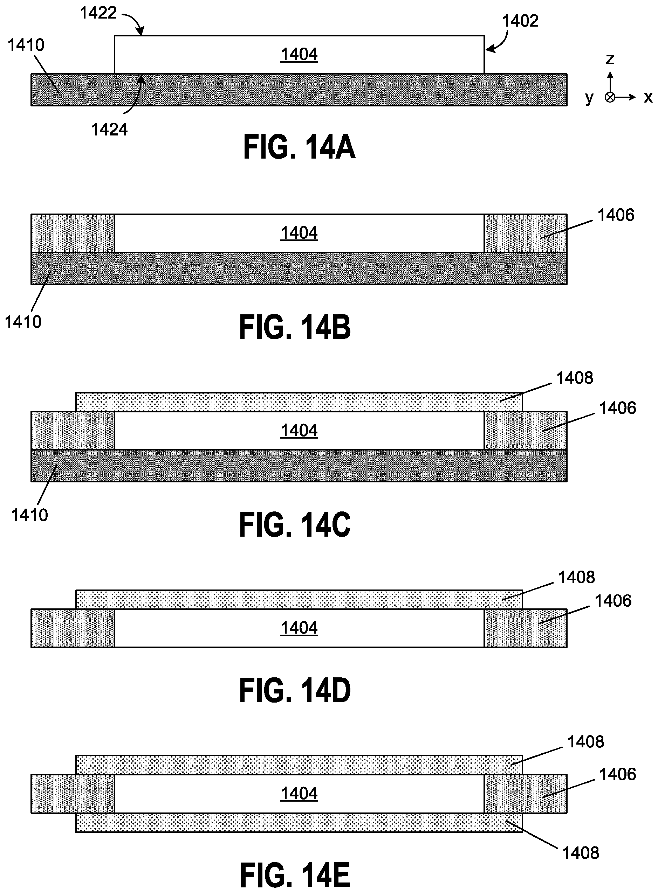

**FIGS. 14A-14E** are cross-sectional side views of a glass core panel with interlocking features evolving into a hybrid panel, in accordance with some embodiments. In some examples, the interlocking features on the glass core panels may be features that extend laterally (in x- or y-dimensions) at edges or sidewalls of a glass core panel, such as those described in FIGS. 14E-14H, or as described elsewhere herein. In some examples, the interlocking features on the glass core panels may be features that extend through a thickness of the glass or a frame in a z-direction substantially orthogonal to a surface of the glass panel, as described elsewhere herein. The glass core panels may be full sized panels, sub-panels, or unit-sized panels. In some examples, the frame comprises CCL. In some examples, the frame comprises organic materials.

**FIG. 14A** illustrates an example glass core panel 1404 after the glass core panel has been attached to a carrier 1410. The glass core panel 1404 comprises a top surface 1422 and a bottom surface 1424 opposite the top surface. In addition, the glass core panel 1404 comprises edges or sidewalls 1402 between the top and bottom surfaces 1422, 1424. The glass core panel 1404 comprises one or more interlocking features (not shown in FIG 14A) at or on the edges or sidewalls 1402. The interlocking features may be any features at edges or sidewalls 1402 of a glass core panel described herein. Advantageously, the interlocking features may block the growth of cracks growth at the boundaries between the glass and the frame.

**FIG. 14B** illustrates the glass core panel 1404 after a frame 1406 has been placed on the panel. The frame 1406 comprises features that are complementary to the interlocking features on glass core panel 1404. After the frame 1406 is placed on glass core panel 1404 features on the glass are seated into complementary features on the frame 1406.

**FIG. 14C** illustrates the glass core panel 1404 and frame 1406 after a polymer material 1408, such as mold or ABF, has been placed on top surface 1422 and over the frame 1406. **FIG. 14D** illustrates the glass core panel 1404 and frame 1406 after carrier 1410 has been removed. **FIG. 14E** illustrates the glass core panel 1404 and frame 1406 after the polymer material 1408 has been placed on bottom surface 1424 and over the frame 1406.

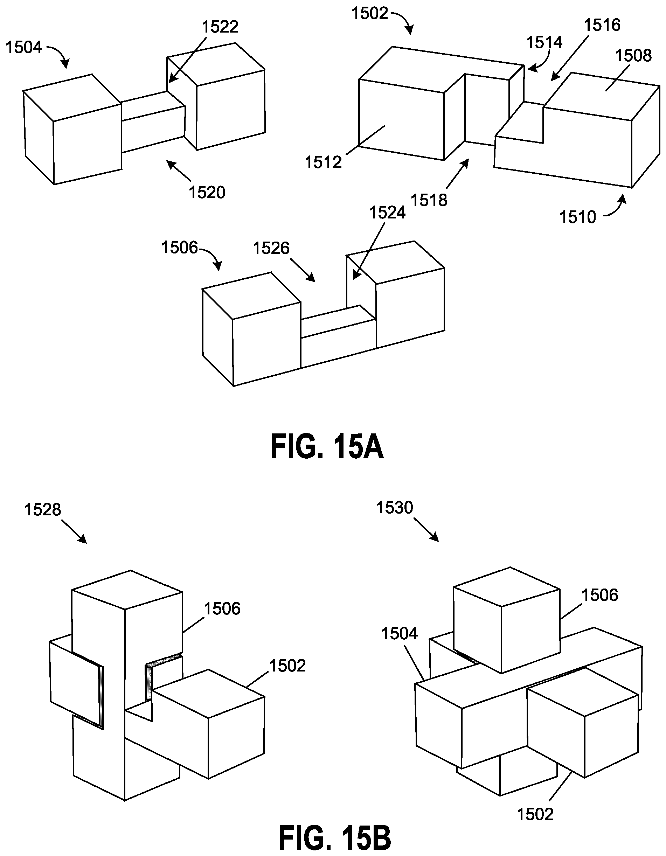

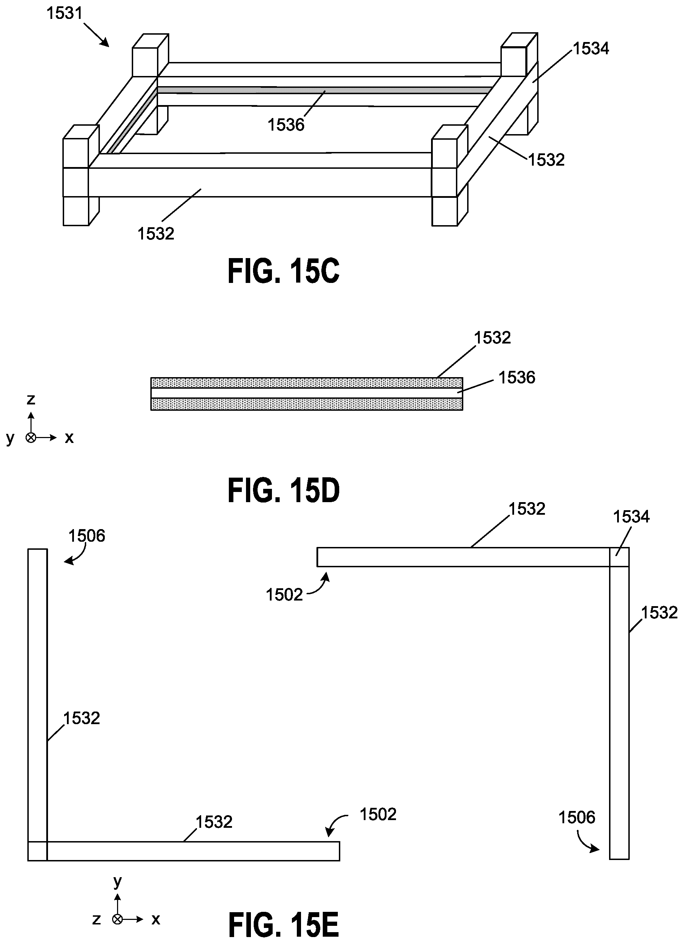

**FIGS. 15A-15C** are isometric views of interlocking features for side members of a frame for a glass core panel and a frame comprising side members with the interlocking features, in accordance with some embodiments. **FIGS. 15D-15G** are plan and cross-sectional views of a frame for a glass core panel that may include the interlocking features for side members of **FIGS. 15A-15C****,** in accordance with some embodiments. The embodiments illustrated in **FIGS. 15A-15G** provide several advantages over known frames for glass core panels. One advantage that the frames use a chemical-free, mechanical interlocking approach for assembling a glass core substrate panel, subpanel, or unit sized panel into a CCL frame.

In addition, the interlocking features provide: (1) simple structure, (2) reliable mechanical properties (without glue/gel), and (3) frame members may be detached in a nondestructive manner so that a frame may be reused. The interlocking features are provided at ends of frame members and strengthen the mechanical properties of an assembled frame. The interlocking features provided at ends of frame members comprise notches that are combined to make one three-dimensional, symmetrical end unit at corners of the frame.

**FIG. 15A** illustrates first, second, and third interlocking features 1502, 1504, and 1506 for side members of a frame for a glass core panel. Each feature comprises a first surface 1508 and second surface 1510 opposite the first surface. Each feature also comprises a third surface 1512 and fourth surface 1514 opposite the third surface, where the third surface 1512 is orthogonal to the first surface 1508.

First interlocking feature 1502 comprises a first notch 1516 on first surface 1508 that extends a distance through a first dimension, e.g., a height, between the first surface 1508 and second surface 1510, wherein the distance of first notch 1516 notch is less than a distance between the first and second surfaces 1508, 1510. First interlocking feature 1502 also comprises a second notch 1518 on third surface 1512 that extends a distance through a second dimension, e.g., a width, between the third surface 1512 and fourth surface 1514.

Second interlocking feature 1504 comprises a third notch 1520 on third surface 1512 that extends a distance in a first dimension, e.g., a height, between the first surface 1508 and second surface 1510, wherein the distance of third notch 1520 notch is equal to a distance between the first and second surfaces 1508, 1510. Second interlocking feature 1504 also comprises a fourth notch 1522 on first surface 1508 that extends a distance through a dimension, e.g., a width, between the third surface 1512 and fourth surface 1514, wherein the distance of fourth notch 1522 is equal to a distance between the third and fourth surfaces 1512, 1514.

Third interlocking feature 1506 comprises a fifth notch 1524 on first surface 1508 that extends a distance partially through a first dimension, e.g., a height, between the first surface 1508 and second surface 1510, wherein the distance of fifth notch 1524 notch is less than a distance between the first and second surfaces 1508, 1510. Third interlocking feature 1506 also comprises a sixth notch 1526 on first surface 1508 that extends a distance through a dimension, e.g., a height, between the first surface 1508 and second surface 1510, wherein the distance of sixth notch 1526 notch is equal to a distance between the first and second surfaces 1508, 1510.

**FIG. 15B** illustrates a stage of assembly 1528 where third interlocking feature 1506 is inserted into a notch of first interlocking feature 1502. **FIG. 15B** also illustrates a stage of assembly 1530 where second interlocking feature 1504 is inserted into a notch of first interlocking feature 1502. **FIG. 15C** illustrates a frame 1531 in which side members 1532 comprise the first, second, and third interlocking features 1502, 1504, and 1506 at each corner 1534 of frame 1531. Frame 1531 comprises slots 1536 along interior edges of the frame. A glass core panel can be secured within the slots 1536. **FIG. 15D** illustrates a side member 1532 of frame 1531.

The frame 1531 may be assembled in by joining two side members 1532 into L-shaped configurations, as illustrated in **FIG. 15E****.** A glass core panel may be inserted into one of the L-shaped configurations. The second L-shaped configuration may then be inserted onto glass core panel. A first interlocking feature 1502 is at one end of the L shape while a third interlocking feature 1506 is at the other end of the L shape, as shown in Fig. 15E.

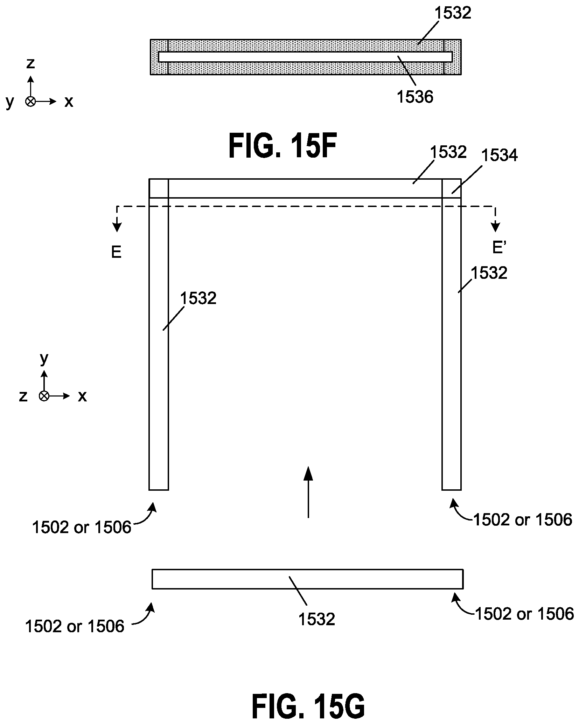

The frame 1531 may be assembled in by joining three side members 1532 into a U-shaped configuration, as illustrated in **FIG. 15G. FIG. 15F** illustrates a cross-section side view of side member 1532 taken along line E-E' of **FIG. 15G****.** A glass core panel may be inserted into the U-shaped configuration. A fourth side member 1532 may then be inserted onto glass core panel. First or third interlocking features 1502, 1506 may be at the ends of the U shape, and the first or third interlocking features 1502, 1506 may be at the ends of the fourth side member 1532, as shown in Fig. 15E.

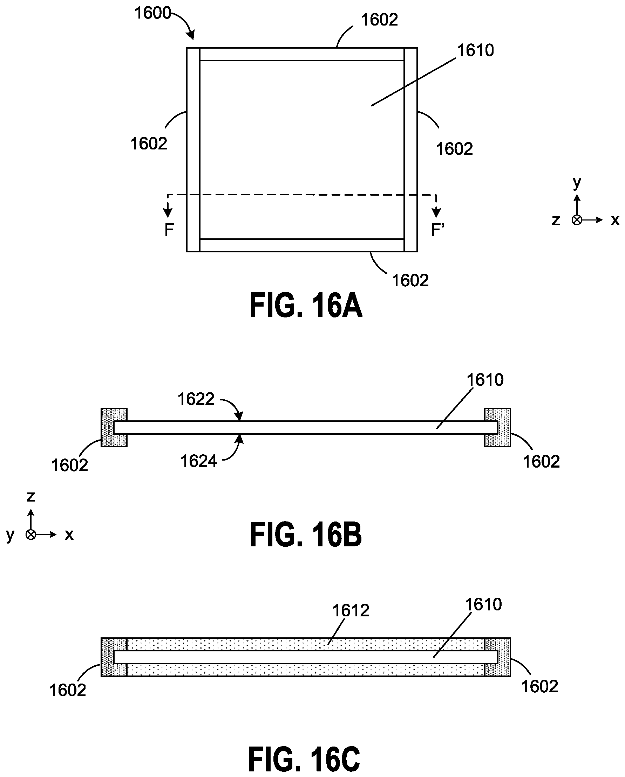

**FIGS. 16A-16G** are plan and cross-sectional views of a frame 1600 for a glass core panel, in accordance with some embodiments. In some examples, the frame 1600 may include the interlocking features for side members illustrated in **FIGS. 15A-15C****.** As may be seen in FIG. 15C, the interlocking features at corners 1534 may extend vertically more than a height of side member 1532. **FIGS. 16A-16G** illustrate methods for reducing the vertical extent of a frame, including reducing the vertical extent of interlocking features at corners 1534. In some examples, the methods illustrated in **FIGS. 16A-16G** may be used to eliminate or minimize the height difference between any frame and any glass core panel.

**FIG. 16A** is a plan view of a frame 1600 comprising side members 1602 and a glass core panel 1610 inserted within the frame. **FIG. 16B** illustrates a cross-sectional side view of the frame 1600 and glass core panel 1610 taken along line F-F' of **FIG. 16A. FIG. 16C** illustrates the frame 1600 and glass core panel 1610 after a polymer material 1612, e.g., ABF, has been formed over top surface 1622 and bottom surface 1624 of glass core panel 1610. Addition of a polymer layer 1612 may eliminate or minimize the height difference between the frame and the glass core panel.

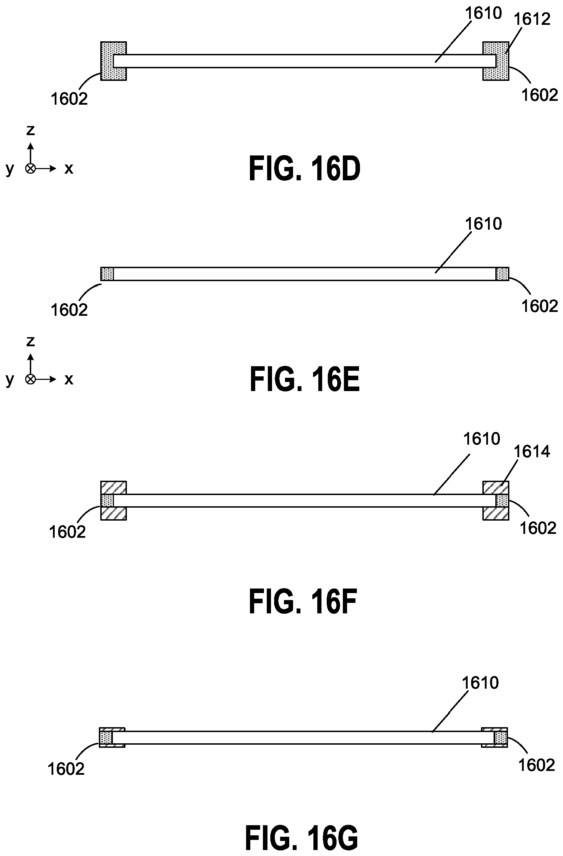

**FIG. 16D** illustrates a cross-sectional side view of the frame 1600 and glass core panel 1610 taken along line F-F' of **FIG. 16A****.** **FIG. 16E** illustrates the frame 1600 and glass core panel 1610 after an operation to reduce the height of side members 1602 of the frame 1600 has been performed. The frame 1600 may comprise CCL material and the height reducing operation may include mechanical grinding or CMP. The mechanical grinding or CMP operation may eliminate or minimize the height difference between the frame and the glass core panel.

**FIG. 16F** illustrates a cross-sectional side view of the frame 1600 and glass core panel 1610 taken along line F-F' of **FIG. 16A****,** after tin 1614 melted on interlocking corner features at a frame corner, e.g., interlocking features 1502, 1504, and 1506. Melting tin on the interlocking corner features may increase the strength of the corner. **FIG. 16G** illustrates the frame 1600 and glass core panel 1610 after an operation to reduce the height of the frame 1600 has been performed. The height reducing operation may include a polishing operation, e.g. CMP. The height reducing operation may eliminate or minimize the height difference between the frame and the glass core panel.

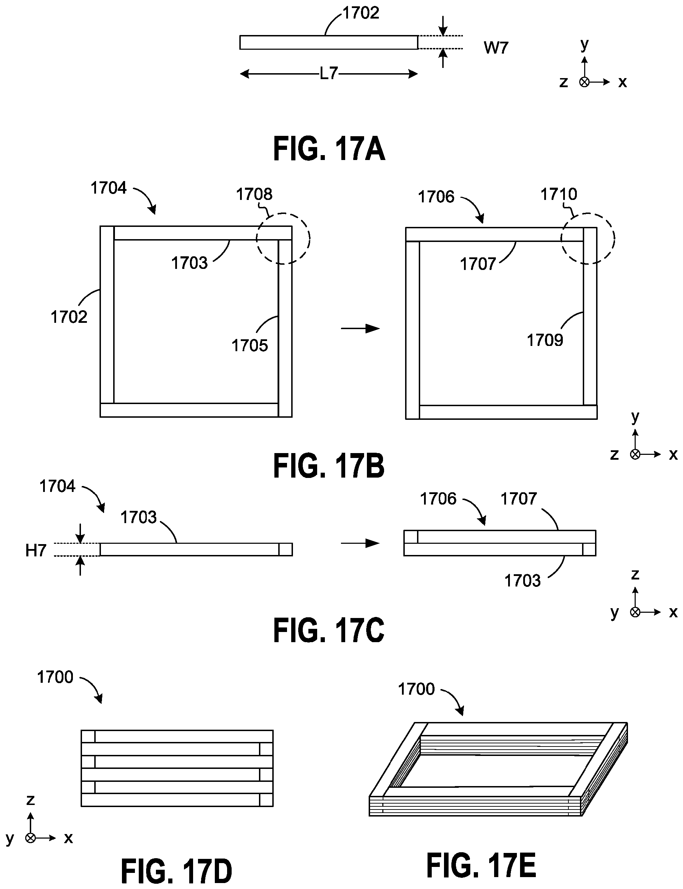

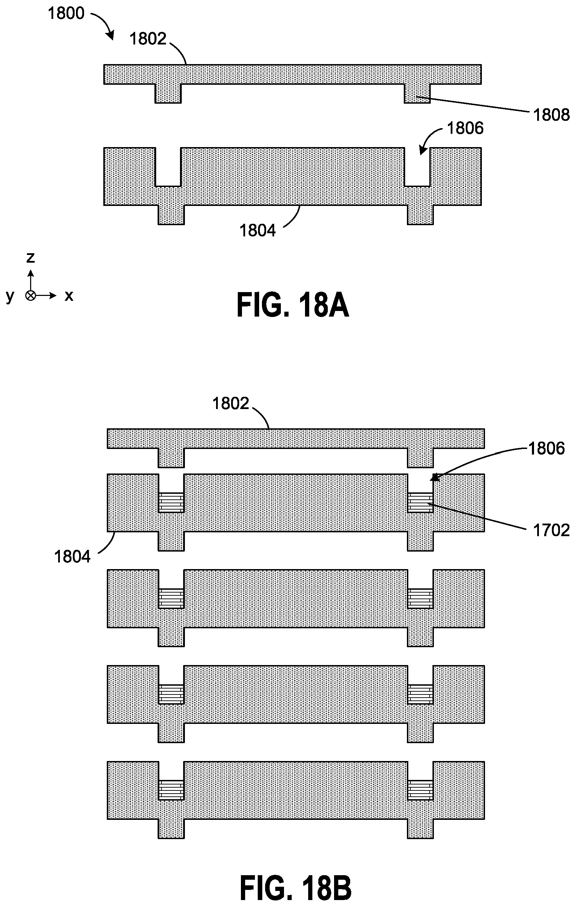

**FIGS. 17A-17E** are isometric, plan, and cross-sectional side views of a frame 1700 for a glass core panel, in accordance with some embodiments. Advantages of the frame 1700 are that it may be fabricated minimal waste and the frame is compatible with existing equipment for manufacturing IC packages. The frame 1700 is fabricated from narrow tapes of pre-preg material laid up in a rectangular arrangement to produce a frame after curing. The pre-preg material may be a strip comprising fiber and resin. **FIGS. 18A-18C** are plan and cross-sectional side views of a molding tool for curing the frame 1700, in accordance with some embodiments. Advantageously, the molding tool can use the same presses used to cure existing frames.

Some current processes to develop a frame generate significantly more waste than usable material, increasing the cost of the frame significantly. Cutting the middle out of a frame, using a router or similar tool, also leads to rounded corners rather than 90° corners. This means the glass panel within the frame must be cut slightly smaller in order to accommodate the rounded corners, increasing waste and cost still further. Advantages of the frame 1700 are that this waste from fabricating frames may be reduced.

**FIG. 17A** illustrates a narrow tape 1702 of pre-preg material that can be laid up in a frame without the need for machining. **FIGS. 17B-17C** shows an initial four tapes of pre-preg material laid up in a first step 1704. As can be seen in circled area 1708, the end of one tape 1705 abuts a side edge of another tape 1703 at a corner in a first step 1704. In a second step 1706, four additional tapes are laid up on to top four the initial tapes. As can be seen in circled area 1710, the end of one tape 1707 abuts a side edge of another tape 1709 at the same corner shown in circled area 1708. However, the end of tape 1705 in the first layer does not overlap with the end of tape 1709 in the second layer. Similarly, the end of tape 1703 in the first layer does not overlap with the end of tape 1707 in the second layer. For example, if an 510 mm wide frame is desired, and the tape is 5 mm wide, each tape should be cut 5 mm shorter than the side length that is desired, e.g. 505 mm. Each subsequent layer should be laid up such that the short side is opposite to where it was in the first layer.

**FIGS. 17D-17E** illustrate side and isometric views of a frame 1700 after the tape layup has been completed, in accordance with some embodiments. As may be seen in **FIGS. 17D-17E****,** the corners alternate with tapes from the long and short sides of the frame. In addition to preventing uneven height at the corners, alternating tapes in this way will improve the structural integrity of the frame.

Tape 1702 of pre-preg material has a width W7, a height H7, and a length L7. In the example illustrated in **FIGS. 17A-17E****,** all pieces of tape 1702 have the same width W7. A method for forming the frame comprises stacking a plurality of layers of strips comprising fiber and resin to form frame side members. Each layer comprises four strips. The length of each strip in a layer is shorter than a length of the frame side member by a distance equal to the width ot the strips.

In some examples, pieces of tape 1702 comprise two or more different widths. For example, frames 906 and 1306F may be formed according to the example illustrated in **FIGS. 17A-17E****,** where the tapes have two different widths. In another example, frame 1306B, may be formed according to the example illustrated in **FIGS. 17A-17E****,** where the tapes have three different widths. Using frame 906 as an example and referring to FIG. 9A, a frame may comprise a plurality of bottom layers having a width W5 and a plurality of top layers having a width W4. The bottom layers of tape form a step 940 or protrusion 924. As another example, a frame is formed from 100 layers of tape where the tapes in the bottom 50 layers have a width of 2 mm and the tapes in the top 50 layers have a width of 1 mm. Accordingly, in some embodiments, method for forming the frame comprises placing strips having a first width in a first layer is wider, and placing strips having a second width in a second layer, where the second width is less than the first width.

Frames fabricated from narrow tapes of pre-preg material as illustrated in **FIGS. 17A-****17E** run the risk of excessive resin bleed out during cure. Excessive resin bleed may lead to resin poor regions and delamination risk. **FIGS. 18A-18C** are plan and cross-sectional side views of a molding tool 1800 for curing the frame formed from pre-preg tapes that mitigates the risk of excessive resin bleed out during cure, in accordance with some embodiments. The molding tool 1800 comprises a top platen 1802 and a bottom platen 1804.

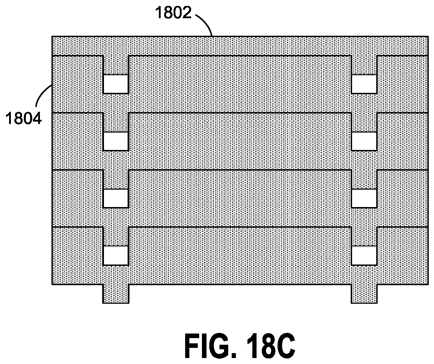

Using molding tool 1800, pre-preg tapes 1702 may be laid up as illustrated in FIGS. 17A-17B within the channels 1806 of the bottom platen 1804. Channel 1806 should be X mm wide to accommodate the width of the pre-preg tape and ensure proper alignment of the tapes prior to cure. The frame channel 1806 should be taller than the height of the final stack of pre-preg tapes. The top platen 1802 can then be placed on top of the pre-preg layup. The top platen includes raised sections 1808 that fit into the frame channel 1806 on top of the pre-preg tape layup. The dimensions of the raised sections 1808 should match those of the frame channel 1806, with a small tolerance to prevent the platens sticking together. **FIG. 18B** illustrates multiple top and bottom platens 1802, 1804 in a process of being stacked together. Laid-up tapes 1702 of pre-preg material are within frame channels 1806. **FIG. 18C** illustrates the multiple top and bottom platens 1802, 1804 stacked together. The stacked top and bottom platens 1802, 1804 may be placed in a press to cure multiple frames in a single machine. After the cure is complete, the frames can be removed from their molds and used with no additional process steps. FIG. 17E shows a completed frame 1700. A glass core panel may be inserted in the frame 1700 using the methods described elsewhere herein.

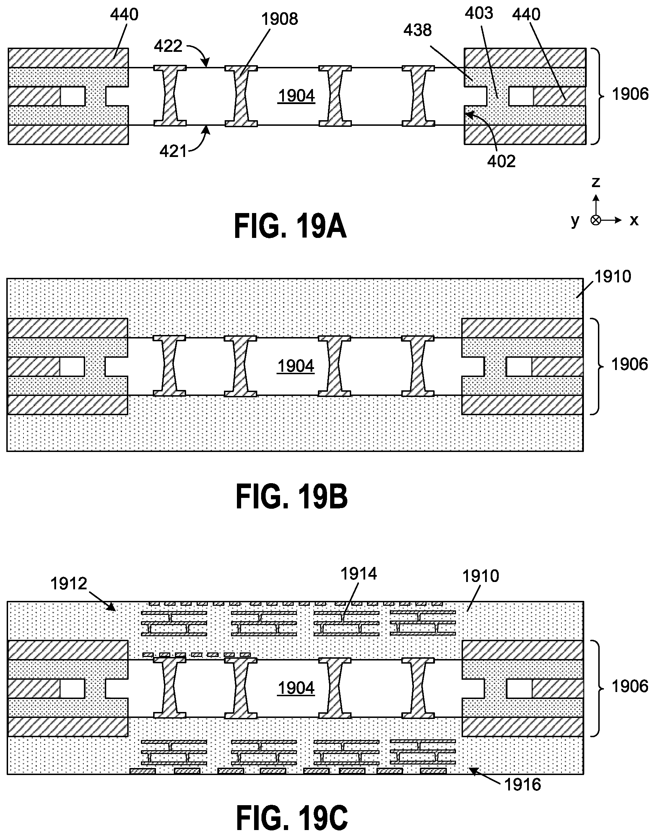

**Referring again to** **FIG. 1****,** a dielectric material may be formed over the assembled glass core panel and frame at operation 124. An example of operation 124 is illustrated in **FIGS. 19A-19B** using the glass core panel and frame shown in FIG. 4D as a starting work piece. **FIG. 4D** is a cross-sectional side view illustrating a glass core panel 404 after it has been inserted into frame 406. **FIG. 19B** is a cross-sectional side view illustrating a glass core panel 1904 after it has been inserted into frame 1906. Glass core panel 1904 may be the same as or similar to glass core panel 404, except that TGVs 1908 are illustrated in glass core panel 1904. Frame 1906 may be the same as or similar to frame 406. The same reference numbers used for certain features in the description of FIGS. 4A-4H may be used to describe the same or similar features in the examples of FIGS. 19A-19C.

**FIG. 19B** is a cross-sectional side view illustrating a glass core panel 1904 within frame 1906 after a dielectric material has been formed over top surface 422 and bottom surface 421 of glass core panel 1904, in accordance with some embodiments. As shown, a dielectric material layer or layers 1910 has been applied to top and bottom surfaces 422, 421.

Dielectric material layer 1910 extends over at least a portion of frame 1906. The composition of dielectric material layers 1910 may vary with implementation. In some embodiments, dielectric material layers 1910 comprise an organic dielectric material, such as any of the materials listed elsewhere herein. In one example, dielectric material layers 1910 comprise ABF.

The dielectric material layers 1910 may be patterned and electrically conductive materials may be deposited upon the patterned dielectric surface to form a routing or redistribution metallization layers (RDL). Conductive material layers, for example comprising predominantly Cu, may be deposited by any known technique, such as plating.

**FIG. 19C** is a cross-sectional side view illustrating build-up of an RDL structure 1912 on a first (e.g., front) side of a hybrid panel comprising glass core panel 1904 and frame 1906, in accordance with some embodiments. RDL structure 1912 includes a plurality of levels of metallization features 1914 embedded within one or more organic dielectric materials 1910. In some further embodiments, another RDL structure 1916 may be formed on a second (e.g., back) side of hybrid panel.

Following hybrid panel build up, a hybrid panel may be singulated into discrete glass-core package substrates. Depending on the structure of the hybrid panel, one or more glass-core package substrates may be formed from a single hybrid panel. For example, individual glass core package substrates may be singulated from any of the exemplary hybrid panels illustrated herein. A single glass core package substrate may evolve from a single hybrid panel, or a plurality (e.g., 4, 16, etc.) glass core package substrates may evolve from a single hybrid panel.

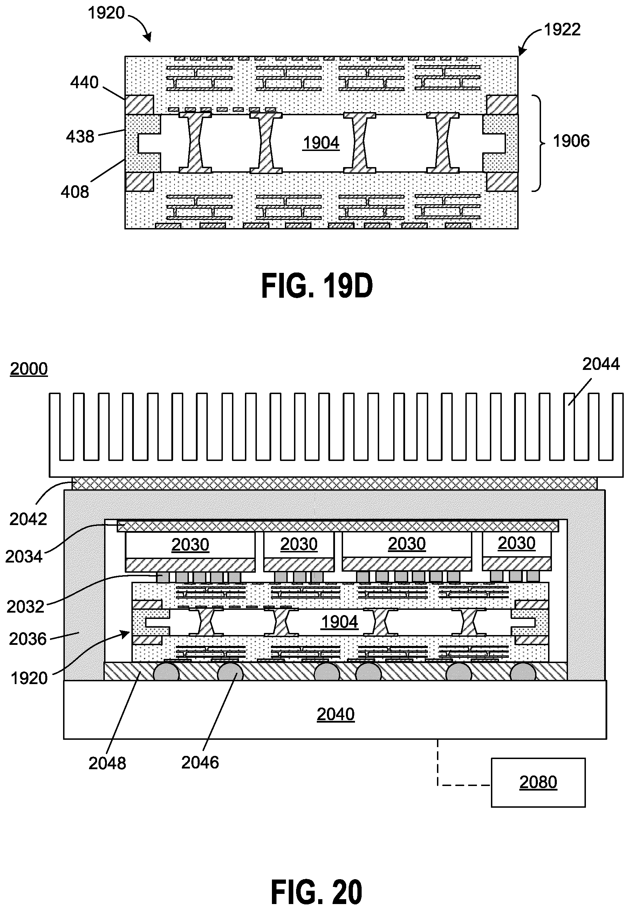

FIG. 19D is a cross-sectional side view illustrating singulation of the hybrid panel illustrated in FIG. 19C into a glass core package substrate 1920. In this example, glass core package substrate 1920 has been cut down along a package substrate edge 1922, eliminating a perimeter of the hybrid panel comprising a portion of frame 1906. In the illustrated example, glass core package substrate 1920 has been singulated along a line that includes holes 403 glass core panel 1904. In various embodiments, some parts of frame 1906 may remain on package substrate edge 1922 as permanent features of glass core package substrate 1920. In addition, all or part of an edge or sidewall feature, such as a protrusion or a cavity may remain on package substrate edge 1922 as permanent features of glass core package substrate 1920. In the illustrated example, polymer material 438 and metal 440 may remain on package substrate edge 1922. Also, in the illustrated example, a portion of protrusion 408 may remain on package substrate edge 1922.

FIGS 19A-19D illustrate glass core panel 1904 evolving to a glass core package substrate 1920. The illustrated example uses glass core panel 1904, which may be the same as or similar to glass core panel 404. In other examples, any glass core panel described herein may evolve into a glass core package substrate according to the operations illustrated in FIGS 19A-19D. For example, glass core panel 304, 326, 336, 346, 356, 504, 534, 544, 554, 564, 574, 584, 604, 704, 724, 804a-804d, 812a-812d, 904, 1004, 1104, 1204, 1304a-1304h, 1404, and 1610 may evolve into a glass core package substrate according to the operations illustrated in FIGS 19A-19D.

**Referring again to** **FIG. 1****,** at operation 126, the panel build operations for IC packaging may be performed. **FIG. 20** is a cross-sectional view illustrating a microelectronic device assembly 2000, which includes glass core package substrate 1920, in accordance with some embodiments. While the example of FIG. 20 uses glass core package substrate 1920, a glass core package substrate formed from any of glass core panel 304, 326, 336, 346, 356, 504, 534, 544, 554, 564, 574, 584, 604, 704, 724, 804a-804d, 812a-812d, 904, 1004, 1104, 1204, 1304a-1304h, 1404, and 1610 may be included in microelectronic device assembly 2000. Microelectronic device assembly 2000 includes a plurality of IC dies 2030 joined to glass core package substrate 1920 with die-level interconnects 2032. However, any single IC die, 3D stacked multichip device, multi-chip composite structure, or the like may be similarly assembled or directly bonded to glass core package substrate 1920.

A thermal interface material (TIM) 2034 is between IC dies 2030 and a heat spreader and/or lid 2036, which extends beyond a perimeter of glass core package substrate 1920, and is mounted to board 2040. Another TIM 2042 is between heat spreader 2036 and a thermal dissipation device 2044, which may be a heat sink, heat pipe or other thermal solution.

Build up on a second side of glass core package substrate 1920 is electrically coupled to a board 2040 with package-level interconnects 2046 (e.g., solder features) that may be at least partially surrounded by underfill material 2048. Board 2040 may include any suitable substrate such as a motherboard, interposer, or the like. Microelectronic device assembly 2000 is coupled to a power supply 2080, for example through one or more of board 2040 and glass core package substrate 1920. Power supply 2080 may include a battery and multi-rail power supply circuitry, such as a switching supply with a voltage converter, etc.

Glass core package substrate 1920 may comprise one or more of the structural features described elsewhere herein. For example, glass core package substrate 1920 may include a layer of bulk glass having a protrusion or cavity on a sidewall or edge with metal or polymer remnants of a frame on the glass.

The various glass core edge features, and methods of forming such features, described herein may be integrated into a wide variety of IC packages and systems that include such IC packages.

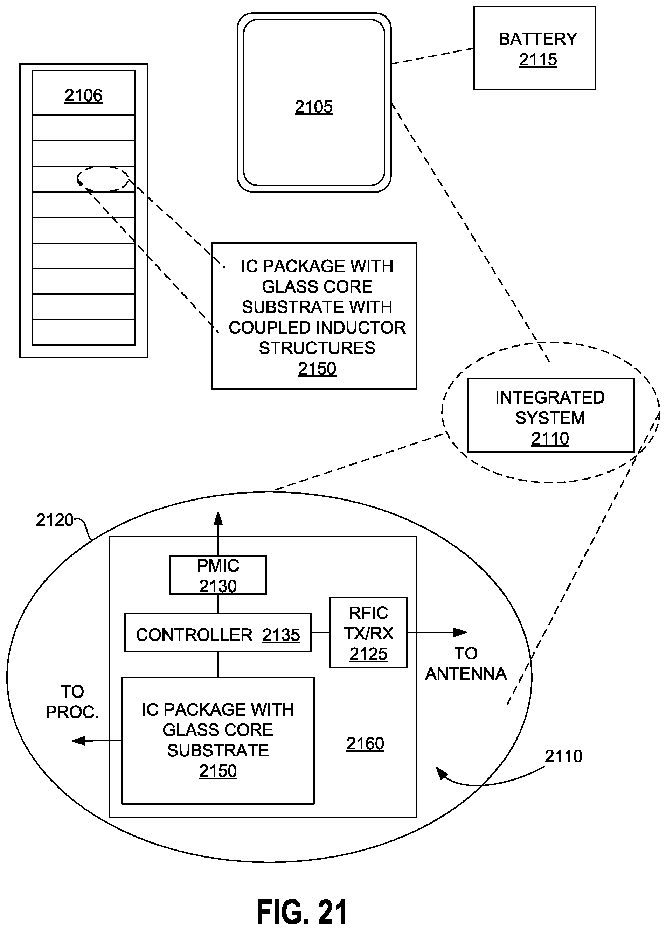

**FIG. 21** illustrates a mobile computing platform and a data server machine employing one or more apparatus comprising IC package with a glass core substrate comprising protrusion or cavity on a sidewall or edge with metal or polymer remnants of a frame on the glass, for example as described elsewhere herein. For example, mobile computing platform 2105 or server machine 2106 may include IC package with a glass core substrate comprising protrusion or cavity on a sidewall or edge with metal or polymer remnants of a frame on the glass die as described elsewhere herein. Server machine 2106 may be any commercial server, for example including any number of high-performance computing platforms disposed within a rack and networked together for electronic data processing. The mobile computing platform 2105 may be any portable device configured for each of electronic data display, electronic data processing, wireless electronic data transmission, or the like. For example, the mobile computing platform 2105 may be any of a tablet, a smart phone, laptop computer, etc., and may include a display screen (e.g., a capacitive, inductive, resistive, or optical touchscreen), a chip-level or package-level integrated system 2110, and a battery 2115.

Whether disposed within the integrated system 2110 illustrated in the expanded view 2120, or as a stand-alone package within the server machine 2106, the integrated system or server machine includes an apparatus comprising IC package with a glass core substrate comprising protrusion or cavity on a sidewall or edge with metal or polymer remnants of a frame on the glass, as described elsewhere herein. System 2150 may be further coupled to a host substrate 2160, along with, one or more of a power management integrated circuit (PMIC) 2130, RF (wireless) integrated circuit (RFIC) 2125 including a wideband RF (wireless) transmitter and/or receiver (TX/RX) (e.g., including a digital baseband and an analog front-end module further comprises a power amplifier on a transmit path and a low noise amplifier on a receive path), and a controller 2135. PMIC 2130 may perform battery power regulation, DC-to-DC conversion, etc., and so has an input coupled to battery 2115 and with an output providing a current supply to other functional modules. As further illustrated, in the exemplary embodiment, RFIC 2125 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 4G, and beyond.

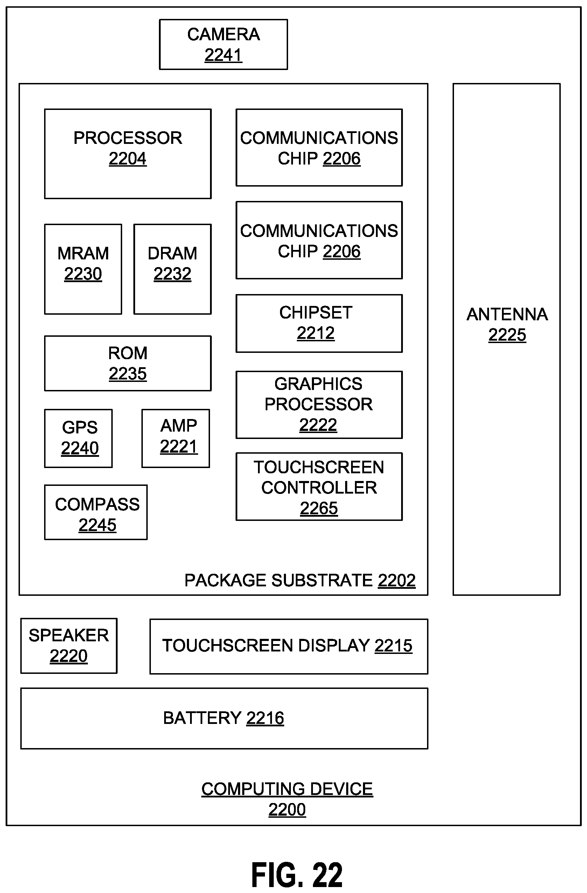

**FIG. 22** is a functional block diagram of an electronic computing device 2200, in accordance with an embodiment of the present invention. The computing device may be found inside mobile computing platform 2105 or server machine 2106, as described elsewhere herein. Device 2200 further includes a package substrate 2202 hosting a number of components, such as, but not limited to, a processor 2204 (e.g., an applications processor). Processor 2204 may be physically and/or electrically coupled to package substrate 2202. In general, the term "processor" or "microprocessor" may refer to any device or portion of a device that processes electronic data from registers and/or memory to transform that electronic data into other electronic data that may be further stored in registers and/or memory. In some examples, one or more of the components of computing device 2200 includes IC package with a glass core substrate, e.g., package substrate 2202, comprising protrusion or cavity on a sidewall or edge with metal or polymer remnants of a frame on the glass, as described elsewhere herein.

In various examples, one or more communication chips 2206 may also be physically and/or electrically coupled to the package substrate 2202. In further implementations, communication chips 2206 may be part of processor 2204. Depending on its applications, computing device 2200 may include other components that may or may not be physically and electrically coupled to package substrate 2202. These other components include, but are not limited to, volatile memory (e.g., DRAM 2232), non-volatile memory (e.g., ROM 2235), flash memory (e.g., NAND or NOR), magnetic memory (MRAM 2230), a graphics processor 2222, a digital signal processor, a crypto processor, a chipset 2212, an antenna 2225, touchscreen display 2215, touchscreen controller 2265, battery 2216, audio codec, video codec, power amplifier 2221, global positioning system (GPS) device 2240, compass 2245, accelerometer, gyroscope, speaker 2220, camera 2241, and mass storage device (such as hard disk drive, solid-state drive (SSD), compact disk (CD), digital versatile disk (DVD), and so forth), or the like..

Communication chips 2206 may enable wireless communications for the transfer of data to and from the computing device 2200. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chip 2206 may implement any of a number of wireless standards or protocols. As discussed, computing device 2200 may include a plurality of communication chips 2206. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

Example 1: An apparatus, comprising: a glass core comprising a top surface and a bottom surface opposite the top surface; a plurality of vias extending between the top and bottom surfaces; and an edge between the top and bottom surfaces comprising one or more protrusions, or one or more cavities, each of the protrusions or cavities comprising a first surface parallel to the top surface, a second surface non-parallel to the top surface, and a polymer or a metal on the first or second surface.

Example 2: The apparatus of example 1, wherein the edge comprises the one or more protrusions and each protrusion comprises a hole through the protrusion, wherein the polymer or the metal is within the hole.

Example 3: The apparatus of any of example 1 or example 2, wherein the edge comprises the one or more protrusions and the protrusions comprise a projection extending away from the first surface in a direction perpendicular to the first surface.

Example 4: The apparatus of any of example 1 or example 2, wherein the edge comprises the one or more protrusions and the protrusions comprise a third surface parallel to the top surface and perpendicular to the edge, wherein the first surface of each protrusion is coplanar with the top surface and the third surface of each protrusion is spaced away from the bottom surface.

Example 5: The apparatus of example 4, wherein the edge comprises the one or more protrusions and the protrusions comprise a distal portion comprising a curved perimeter.

Example 6: The apparatus of example 1, wherein the edge comprises the one or more cavities and the glass core comprises a hole through at least one of the cavities, wherein the polymer or metal is within the hole.

Example 7: The apparatus of example 1, wherein the first surface comprises surface features comprises shapes that repeat in a pattern, and the surface features have a height perpendicular to the first surface of between 100 µm to 500µm.

Example 8: The apparatus of example 1, wherein the first surface comprises an average surface roughness of between 1 µm to 10 µm.

Example 9: The apparatus of any of examples 1 through 8, further comprising a frame surrounding the glass core, the frame comprising an upper surface, a lower surface opposite the upper surface, and an interior edge between the upper and lower surfaces, wherein the protrusions are first protrusions and the cavities are first cavities, and: wherein the edge of the glass core comprises the one or more first protrusions, and the interior edge of the frame comprises one or more second cavities to mate with the first protrusions.

Example 10: The apparatus of example 9, wherein each of the second cavities comprise a third surface parallel to the upper surface and perpendicular to the interior edge, wherein the third surface comprises comprises an average surface roughness of between 1 µm to 10 µm.

Example 11: The apparatus of example 1, further comprising a frame surrounding the glass core, the frame comprising an upper surface, a lower surface opposite the upper surface, and an interior edge between the upper and lower surfaces, wherein the protrusions are first protrusions and the cavities are first cavities, and: wherein the edge of the glass core comprises the one or more first cavities, and the interior edge of the frame comprises one or more second protrusions to mate with the first cavities.

Example 12: The apparatus of example 9 or example 11, wherein the frame comprises a copper clad laminate or a composition comprising an organic material, and a mold material is between the frame and the glass core.

Example 13: An apparatus, comprising: an integrated circuit (IC) package substrate, wherein the IC package substrate comprises a glass core, the glass core comprising: a top surface, a bottom surface opposite the top surface, and a sidewall between the top and bottom surfaces; a plurality of vias extending between the top and bottom surfaces; a plurality of protrusions or a plurality of cavities on the sidewall extending between the top and bottom surfaces; and a polymer material between first and second adjacent protrusions, or a polymer material or a metal between first and second adjacent cavities.

Example 14: The apparatus of example 13, wherein the glass core comprises the plurality of protrusions and each protrusion comprises a proximal end at the sidewall and distal portion away from the sidewall, and the proximal end is narrower than the distal portion.

Example 15: The apparatus of example 14, wherein the distal portion comprises a shape with a curved perimeter.

Example 16: The apparatus of example 13 or example 14, wherein the glass core comprises the plurality of protrusions, further comprising a frame surrounding the glass core, wherein the frame comprises an interior edge comprising one or more cavities, wherein each cavity comprises a shape that is a complement of a shape of one of the protrusions.

Example 17: The apparatus of any of examples 13, 14, or 16, further comprising a metal or a pre-preg material over the plurality of protrusions or the plurality of cavities.

Example 18: A method, comprising: receiving a frame; receiving a glass core comprising an edge, a plurality of first protrusions or a plurality of first cavities at the edge, and a plurality of vias extending through the glass core; attaching the frame to the glass core by placing second protrusions or second cavities on an interior edge of the frame in an interlocking position with respect to the first protrusions or the first cavities; and forming a level of metallization features over a top surface of the glass core and coupled to the vias through one or more semi-additive processes.

Example 19: The method of example 18, wherein the frame comprises frame side members, further comprising forming the frame by stacking a plurality of layers of strips comprising fiber and resin to form frame side members, each layer comprising four strips, wherein a length of each strip in a layer is shorter than a length of the frame side members.

Example 20: The method of example 19, wherein a first width of the strips in a first layer is wider than a second width of the strips in a second layer.

Example 21: The method of example 18, wherein the frame comprises side members, further comprising forming the frame by inserting a first notch at an end of a first frame side into a second notch at an end of a second frame side.

## Claims

1. An apparatus comprising:
a glass core comprising a top surface and a bottom surface opposite the top surface;
a plurality of vias extending between the top and bottom surfaces; and
an edge between the top and bottom surfaces comprising one or more protrusions, or one or more cavities, each of the protrusions or cavities comprising a first surface parallel to the top surface, a second surface non-parallel to the top surface, and a polymer or a metal on the first or second surface.

2. The apparatus of claim 1, wherein the edge comprises the one or more protrusions and each protrusion comprises a hole through the protrusion, wherein the polymer or the metal is within the hole.

3. The apparatus of claim 1, wherein the edge comprises the one or more protrusions and the protrusions comprise a projection extending away from the first surface in a direction perpendicular to the first surface.

4. The apparatus of claim 1, wherein the edge comprises the one or more protrusions and the protrusions comprise a third surface parallel to the top surface and perpendicular to the edge, wherein the first surface of each protrusion is coplanar with the top surface and the third surface of each protrusion is spaced away from the bottom surface.

5. The apparatus of claim 4, wherein the edge comprises the one or more protrusions and the protrusions comprise a distal portion comprising a curved perimeter.

6. The apparatus of claim 1, wherein the edge comprises the one or more cavities and the glass core comprises a hole through at least one of the cavities, wherein the polymer or metal is within the hole.

7. The apparatus of claim 1, wherein the first surface comprises surface features comprises shapes that repeat in a pattern, and the surface features have a height perpendicular to the first surface of between 100 µm to 500µm.

8. The apparatus of claim 1, wherein the first surface comprises an average surface roughness of between 1 µm to 10 µm.

9. The apparatus of claim 1, further comprising a frame surrounding the glass core, the frame comprising an upper surface, a lower surface opposite the upper surface, and an interior edge between the upper and lower surfaces, wherein the protrusions are first protrusions and the cavities are first cavities, and:
wherein the edge of the glass core comprises the one or more first protrusions, and the interior edge of the frame comprises one or more second cavities to mate with the first protrusions.

10. The apparatus of claim 9, wherein each of the second cavities
comprise a third surface parallel to the upper surface and perpendicular to the interior edge, wherein the third surface comprises an average surface roughness of between 1 µm to 10 µm.

11. The apparatus of claim 1, further comprising a frame surrounding the glass core, the frame comprising an upper surface, a lower surface opposite the upper surface, and an interior edge between the upper and lower surfaces, wherein the protrusions are first protrusions and the cavities are first cavities, wherein:
wherein the edge of the glass core comprises the one or more first cavities, and the interior edge of the frame comprises one or more second protrusions to mate with the first cavities.

12. The apparatus of claim 9, wherein the frame comprises a copper clad laminate or a composition comprising an organic material, and a mold material is between the frame and the glass core.

13. The apparatus of claim 1, further comprising an integrated circuit (IC) package substrate, wherein the IC package substrate comprises the glass core;
the one or more protrusions extend between the top and bottom surfaces and comprise a proximal end at the edge and distal portion away from the edge; and
the proximal end is narrower than the distal portion; or
the distal portion comprises a shape with a curved perimeter.

14. A method comprising:
receiving a frame;
receiving a glass core comprising an edge, a plurality of first protrusions or a plurality of first cavities at the edge, and a plurality of vias extending through the glass core;
attaching the frame to the glass core by placing second protrusions or second cavities on an interior edge of the frame in an interlocking position with respect to the first protrusions or the first cavities; and
forming a level of metallization features over a top surface of the glass core and coupled to the vias through one or more semi-additive processes.

15. The method of claim 14, wherein the frame comprises frame side members, further comprising forming the frame by stacking a plurality of layers of strips comprising fiber and resin to form frame side members, each layer comprising four strips, wherein a length of each strip in a layer is shorter than a length of the frame side members.
